# EUROPEAN PATENT SPECIFICATION

(11) **EP 3 168 867 B1**
(45) Date of publication and mention of the grant of the patent: **21.08.2019**
(21) Application number: 14897355.5
(22) Date of filing: 10.07.2014
(51) Int. Cl.: H01L 23/36, H01L 23/38, H05K 7/20, H01L 23/367, H01L 23/373

(54) **HEAT DISSIPATION COMPONENT AND HEAT DISSIPATION COMPONENT MANUFACTURING METHOD**
WÄRMEABLEITUNGSKOMPONENTE UND VERFAHREN ZUR HERSTELLUNG DER WÄRMEABLEITUNGSKOMPONENTE
COMPOSANT DE DISSIPATION DE CHALEUR ET PROCÉDÉ DE FABRICATION DE COMPOSANT DE DISSIPATION DE CHALEUR

(43) Date of publication of application: 17.05.2017
(73) Proprietor: Fujitsu Limited, Kawasaki-shi, Kanagawa 211-8588 (JP)
(72) Inventor: SUZUKI, Takashi, Kawasaki-shi Kanagawa 211-8588 (JP); NAKAGAWA, Kanae, Kawasaki-shi Kanagawa 211-8588 (JP)
(74) Representative: Haseltine Lake Kempner LLP
(86) International application number: PCT/JP2014/068498
(87) International publication number: WO 2016/006089

(56) References cited:
- EP-A1- 2 293 328
- EP-A1- 3 098 844
- WO-A1-2013/103009
- JP-A- H 077 110
- JP-A- H01 201 941
- JP-A- 2001 110 955
- JP-A- 2002 134 970
- JP-A- 2002 314 013
- JP-A- 2006 024 948
- JP-A- 2006 156 465
- JP-A- 2011 222 706
- JP-A- 2012 138 405
- JP-U- S58 185 150
- US-B1- 8 537 554

## Description

### FIELD

Technology disclosed herein relates to a heat dissipating component, a manufacturing method for a heat dissipating component, an electronic device, a manufacturing method for an electronic device, an integrated module, and an information processing system.

### BACKGROUND

In an electronic device provided with an electronic component that requires heat dissipation, sometimes a heat dissipating component thermally connected to the electronic component is employed to dissipate heat.

### Related Patent Documents

Patent Document 1 Japanese Patent Application Laid-Open (JP-A) No. H07-7110
Patent Document 2 JP-A No. H05-326762
Patent Document 3 JP-A No. 2009-152537

Document US8537554 discloses a structured relief dielectric heat sink comprising a stress relief void in a fin.

Document JP2006156465 discloses a heat dissipation member for an electronic apparatus which effectively dissipates heat from an electronic component.

Document JP2002314013 discloses a heat dissipating material which has little warpage that comprises inter-fin grooves formed into the shapes of recessed arcs.

In an electronic device provided with a heat dissipating component like that described above, there is a general desire to be able to reduce costs.

### SUMMARY

An object of one aspect of technology disclosed herein is to reduce the costs of an electronic device.

A heat dissipating component is disclosed as recited in claim 1. A manufacturing method for a heat dissipating component is disclosed as recited in claim 9.

In accordance with the technique disclosed in the present application, the cost of the electronic device to be reduced.

### BRIEF DESCRIPTION OF DRAWINGS

Fig. 1 is a perspective view of an electronic device according to a first exemplary embodiment.
Fig. 2 is a cross-section as viewed from the front of an electronic device according to the first exemplary embodiment.
Fig. 3 is a diagram for explaining a manufacturing method for an electronic device according to the first exemplary embodiment.
Fig. 4 is a diagram for explaining a manufacturing method for an electronic device according to the first exemplary embodiment.
Fig. 5 is a diagram illustrating an information processing system according to the first exemplary embodiment.
Fig. 6 is a cross-section as viewed from the front illustrating a modified example of an electronic device according to the first exemplary embodiment.
Fig. 7 is a diagram for explaining a manufacturing method for an electronic device according to a second exemplary embodiment.
Fig. 8 is a diagram for explaining a manufacturing method for an electronic device according to the second exemplary embodiment.
Fig. 9 is a diagram for explaining a manufacturing method for an electronic device according to the second exemplary embodiment that forms part of the invention.
Fig. 10 is a diagram for explaining a manufacturing method for an electronic device according to the second exemplary embodiment.
Fig. 11 is a perspective view of an electronic device according to the second exemplary embodiment that forms part of the invention.
Fig. 12 is a cross-section as viewed from the front illustrating an electronic device according to the second exemplary embodiment that forms part of the invention.
Fig. 13 is a diagram for explaining a state in which an electronic device according to the second exemplary embodiment that forms part of the invention has fallen to the floor.
Fig. 14 is a diagram for explaining a manufacturing method of an electronic device according to a third exemplary embodiment.
Fig. 15 is a diagram for explaining a manufacturing method of an electronic device according to the third exemplary embodiment.
Fig. 16 is a perspective view of an electronic device according to the third exemplary embodiment that forms part of the invention.
Fig. 17 is a diagram for comparing output voltages of electronic devices according to the first exemplary embodiment to the third exemplary embodiment.
Fig. 18 is a diagram for explaining a modified example of a manufacturing method of an electronic device according to the third exemplary embodiment.
Fig. 19 is a diagram for explaining a manufacturing method of an electronic device according to a fourth exemplary embodiment.
Fig. 20 is a diagram for explaining a manufacturing method of an electronic device according to the fourth exemplary embodiment.
Fig. 21 is a partially enlarged perspective view of a heat dissipating sheet according to the fourth exemplary embodiment.
Fig. 22 is a diagram for explaining a manufacturing method of an electronic device according to the fourth exemplary embodiment that forms part of the invention.
Fig. 23 is a diagram for explaining a manufacturing method of an electronic device according to the fourth exemplary embodiment.
Fig. 24 is a perspective view of an electronic device according to the fourth exemplary embodiment that forms part of the invention.
Fig. 25 is a cross-section as viewed from the front illustrating an electronic device according to the fourth exemplary embodiment that forms part of the invention.
Fig. 26 is a diagram for explaining a manufacturing method of an electronic device according to a fifth exemplary embodiment.
Fig. 27 is a diagram for explaining a manufacturing method of an electronic device according to the fifth exemplary embodiment.
Fig. 28 is a partially enlarged perspective view of a heat dissipating sheet according to the fifth exemplary embodiment.
Fig. 29 is a diagram for explaining a manufacturing method of an electronic device according to the fifth exemplary embodiment.
Fig. 30 is a cross-section as viewed from the side illustrating a first mold for manufacturing of an electronic device according to a sixth exemplary embodiment.
Fig. 31 is a diagram for explaining a manufacturing method of an electronic device according to the sixth exemplary embodiment.
Fig. 32 is a diagram for explaining a manufacturing method of an electronic device according to the sixth exemplary embodiment.
Fig. 33 is a cross-section as viewed from the front illustrating an electronic device according to the sixth exemplary embodiment that forms part of the invention.
Fig. 34 is a cross-section as viewed from the side illustrating an electronic device according to the sixth exemplary embodiment.
Fig. 35 is a diagram for explaining a manufacturing method of an electronic device according to a seventh exemplary embodiment that forms part of the invention.
Fig. 36 is an enlarged view of graining formed on an electronic device according to the seventh exemplary embodiment.
Fig. 37 is a cross-section as viewed from the front illustrating a first modified example of an electronic device according to the seventh exemplary embodiment that forms part of the invention.
Fig. 38 is an enlarged view of a fine periodic structure in a first modified example of an electronic device according to the seventh exemplary embodiment.
Fig. 39 is a cross-section as viewed from the front illustrating a second modified example of an electronic device according to the seventh exemplary embodiment that forms part of the invention.
Fig. 40 is a diagram illustrating an integrated module according to an eighth exemplary embodiment.
Fig. 41 is a diagram illustrating an information processing system according to the eighth exemplary embodiment.
Fig. 42 is a diagram illustrating a usage state of an information processing system according to a first example application of the eighth exemplary embodiment.
Fig. 43 is a diagram illustrating a usage state of an information processing system according to a second example application of the eighth exemplary embodiment.
Fig. 44 is a diagram illustrating a usage state of an information processing system according to a third example application of the eighth exemplary embodiment.
Fig. 45 is a diagram illustrating a usage state of an information processing system according to a fourth example application of the eighth exemplary embodiment.
Fig. 46 is a diagram illustrating a usage state of an information processing system according to a fifth example application of the eighth exemplary embodiment.

### DESCRIPTION OF EMBODIMENTS

### First Exemplary Embodiment

Explanation follows regarding a first exemplary embodiment of technology disclosed herein.

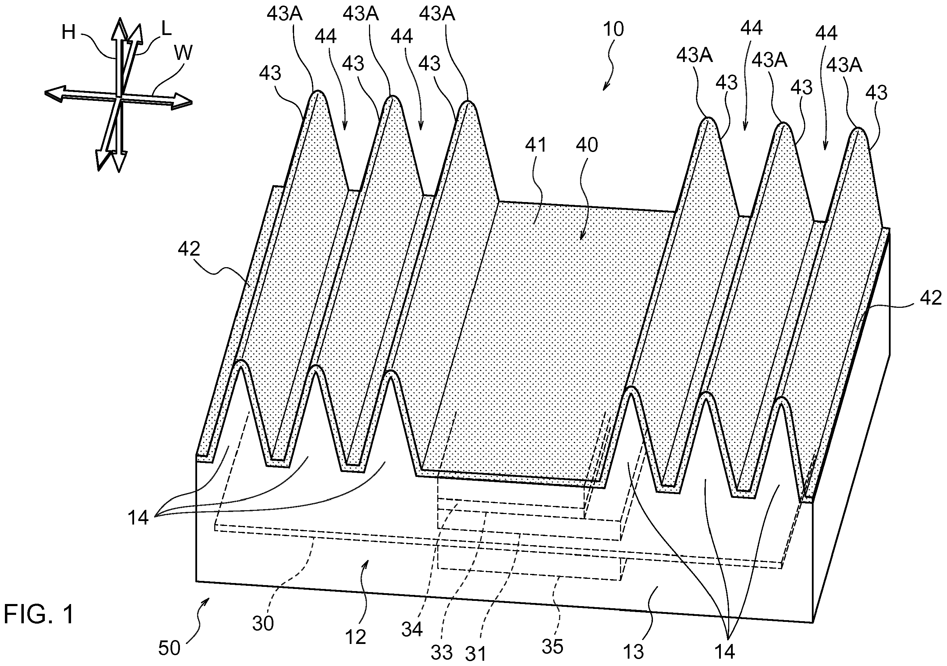

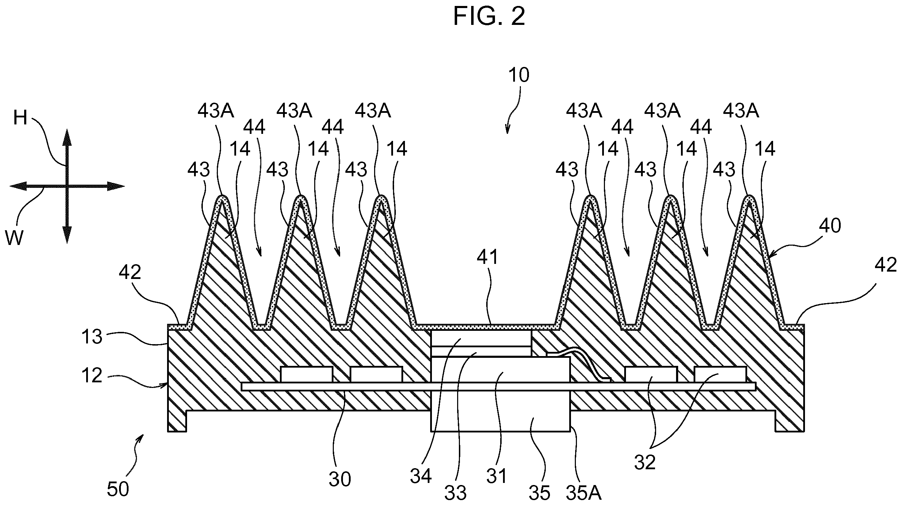

As illustrated in Fig. 1 and Fig. 2, an electronic device 10 according to the first exemplary embodiment includes a main body 12, a substrate 30, and a heat dissipating sheet 40.

In each of the drawings, the arrow W, the arrow L, and the arrow H respectively indicate the width direction, length direction, and height direction of the electronic device 10. The width direction, length direction, and height direction of the electronic device 10 are referred to below as the width W direction, the length L direction, and the height H direction.

The main body 12 includes a flat cuboidal base 13, and plural protrusions 14 that project out from the base 13 toward the upper side in the height H direction. The main body 12 is formed by molding as described below, and is formed from resin (for example, polyamide resin), which is an example of a "first material".

As illustrated in Fig. 2, the substrate 30 is formed in a flat plate shape, and is disposed with its thickness direction in the height H direction. Packaged components that include a thermoelectric element 31 serving as an example of an "electronic component", and a communication component 32 serving as an example of a "communication section", are packaged on the substrate 30. The packaged components of the substrate 30, including the thermoelectric element 31, the communication component 32, and the like, are connected together by a circuit pattern formed on the substrate 30. The packaged components such as the thermoelectric element 31 and the communication component 32, and the substrate 30 are encapsulated by the resin base 13 of the main body 12.

A heat dissipating face of the thermoelectric element 31 is thermally connected to a connecting portion 41 of the heat dissipating sheet 40, described below, through a connecting member 33 and a heat spreader 34. A heat conducting member 35 is disposed at a heat absorbing face side of the thermoelectric element 31. The heat conducting member 35 is thermally connected to the heat absorbing face of the thermoelectric element 31. A portion 35A at the opposite side of the heat conducting member 35 to the thermoelectric element 31 projects out from a bottom face of the main body 12, and is exposed to the exterior.

The heat dissipating sheet 40 is formed from a second material having higher thermal conductivity than the first material that forms the main body 12. In the first exemplary embodiment, the material that forms the heat dissipating sheet 40 is graphite (carbon) as an example. The heat dissipating sheet 40 is provided to the height H direction upper side of the main body 12 and covers the main body 12 from the height H direction upper side.

The connecting portion 41 is formed at a width W direction central portion of the heat dissipating sheet 40 and is thermally connected to the thermoelectric element 31 described above, and an edge portion 42 is formed at both width W direction end portions of the heat dissipating sheet 40. The connecting portion 41 and the edge portions 42 are formed with their thickness directions in the height H direction. The positions (heights) of the connecting portion 41 and the edge portions 42 in the height H direction are, as an example, aligned with each other. The connecting portion 41 and the edge portions 42 are thermally connected to fins 43, described below, at positions other than apexes of the fins 43.

At both sides of the connecting portion 41, the heat dissipating sheet 40 is formed with plural of the bent fins 43. The plural fins 43 are formed with their height directions in the height H direction. Each of the fins 43 has a pointed shape (a shape with an isosceles triangle-shaped cross-section) that narrows in width on progression toward an apex 43A. The plural fins 43 are, as an example, aligned at the same height.

As illustrated in Fig. 1, the plural fins 43 formed at one side or another side of the heat dissipating sheet 40 in the width W direction are arrayed in the width W direction, and the length direction of each of the fins 43 extends in the length L direction. The length L direction, this being the direction in which the fins 43 extend, is an example of a "direction intersecting an arrayed direction of plural fins". As an example of being thermally connected at positions other than apexes, one fin 43 and another fin 43 are connected by a bottom portion 44A.

Grooves 44 having V-shaped cross-sections are formed between the plural fins 43. The inner side of the fins 43 and the grooves 44 are each open in the length L direction, this being the length direction of each of the fins 43. The heat dissipating sheet 40 including the plural fins 43, the connecting portion 41, and the edge portions 42 is, for example, formed by pressing. A resin that forms the protrusions 14 is filled into the inner side of the fins 43, and the fins 43 are supported by the protrusions 14 from the inner side of the fins 43.

The heat dissipating sheet 40 is integrated with the resin main body 12 by molding. The entire surface of the heat dissipating sheet 40 including the surface of the fins 43 is exposed to the exterior.

In the electronic device 10 according to the first exemplary embodiment, a structure that remains after the thermoelectric element 31, the connecting member 33, the heat spreader 34, the heat conducting member 35, and the substrate 30 have been removed from the electronic device 10 forms a heat dissipating component 50. Namely, the heat dissipating component 50 includes the main body 12 and the heat dissipating sheet 40.

Next, explanation follows regarding a manufacturing method for the electronic device 10 including the heat dissipating component 50 according to the first exemplary embodiment.

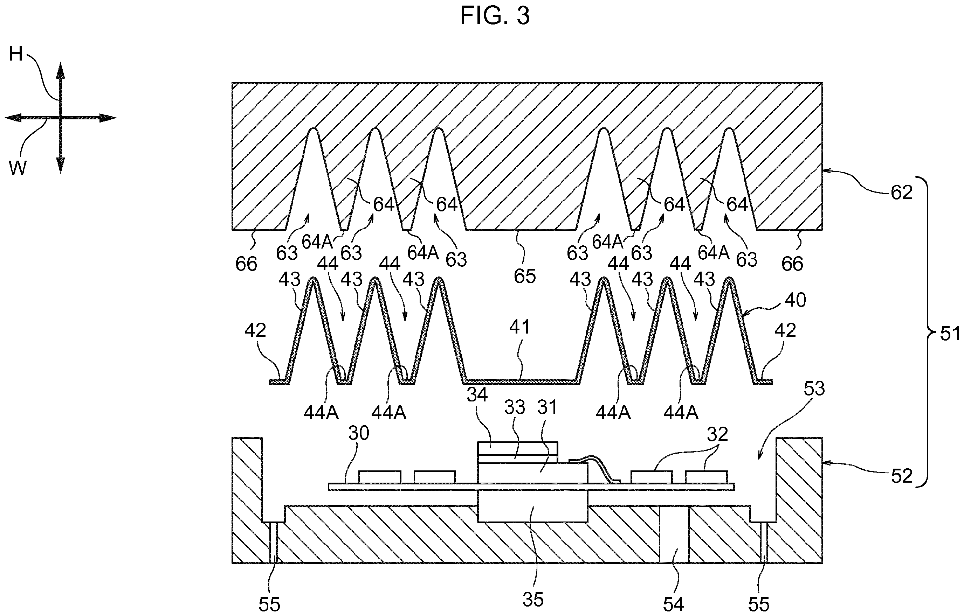

The electronic device 10 illustrated in Fig. 1, as an example, is manufactured using a mold 51 illustrated in Fig. 3. The mold 51 includes a first mold 52 and a second mold 62. As an example, the first mold 52 is a fixed mold, and the second mold 62 is a movable mold.

A first cavity 53 is formed in the first mold 52 indented toward the lower side in the height H direction. The first cavity 53 has depth equivalent to the height of the base 13 (see Fig. 2). The substrate 30, onto which the thermoelectric element 31, the communication component 32, the connecting member 33, the heat spreader 34, the heat conducting member 35, and the like are mounted, is housed in the first cavity 53. An injection port 54 for injecting resin into the mold 51, and exhaust outlets 55 for removing air from the mold 51, are formed in the first mold 52. As an example, the injection port 54 is open toward the inner side of plural second cavities 63 formed in the second mold 62, described below.

Plural of the second cavities 63 are formed in the second mold 62 in a row in the width W direction, indented toward the upper side in the height H direction. Each of the second cavities 63 is formed to match the outer profile and size of the plural fins 43 formed on the heat dissipating sheet 40, described above, and is formed with an inverted V-shaped cross-section. The heat dissipating sheet 40 is attached to the second mold 62, and the plural fins 43 are housed in the plural second cavities 63. Pointed portions between the plural second cavities 63 are formed as projections 64 that project out toward the first mold 52 side, and that are inserted into the grooves 44 between the plural fins 43.

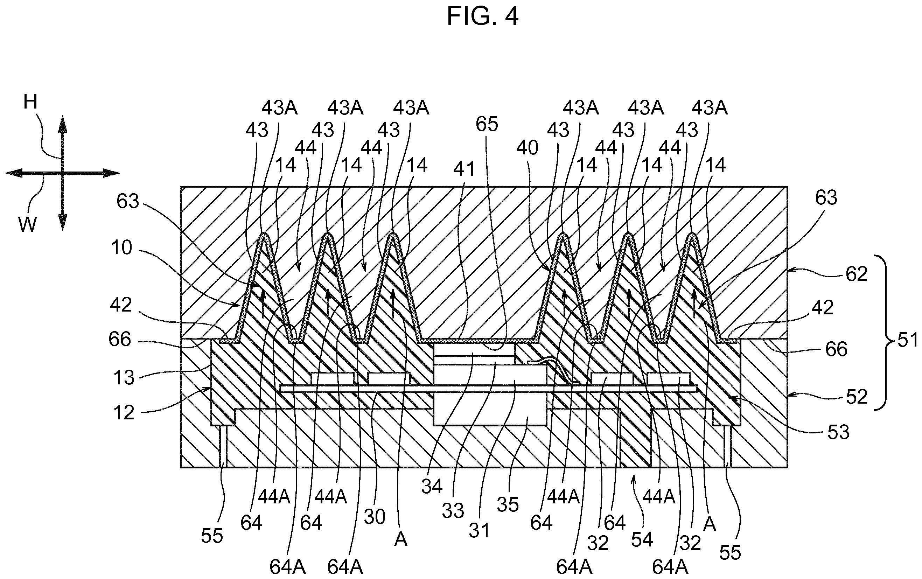

Out of the lower faces of the second mold 62 at the first mold 52 side of the second mold 62, opposing faces 65, 66 that oppose the connecting portion 41 and the edge portions 42 and leading end portions 64A of the projections 64 are, as an example, aligned at the same height. As illustrated in Fig. 4, the opposing faces 65, 66 respectively about the connecting portion 41 and the edge portions 42 in a state in which the heat dissipating sheet 40 is attached to the second mold 62. Moreover, the bottom portions 44A of the grooves 44 formed in the heat dissipating sheet 40 abut the leading end portions 64A of the projections 64 that are inserted into the grooves 44.

The electronic device 10 is manufactured under the following principles using the above mold 51.

First, the substrate 30, on which the thermoelectric element 31, the communication component 32, the connecting member 33, the heat spreader 34, the heat conducting member 35, and the like are mounted, is housed in the first cavity 53 in the first mold 52. The heat dissipating sheet 40, in which the plural bent fins 43 have been formed in advance by pressing, is housed in the second cavities 63 in the second mold 62.

Then, in a state in which the heat dissipating sheet 40 and the substrate 30 are thus set up in the mold 51, the first mold 52 and the second mold 62 are assembled together (see Fig. 4). The state in which the first mold 52 and the second mold 62 are assembled together in this manner is an example of a "set state".

Next, resin, which is an example of a "first material", is injected in a molten state into the mold 51, toward the inner side of the fins 43 through the injection port 54. The resin injected into the mold 51 flows from the inner side of the fins 43 toward the apexes 43A of the fins 43 as indicated by the arrows A in Fig. 4, and is filled into the inner side of the fins 43. The fins 43 bulge and make close contact with to inner faces of the second cavities 63 due to the resin being filled into the inner side of the fins 43. Note that through-holes that allow the resin to pass may be formed in the substrate 30 to facilitate the in-flow of the resin injected into the mold 51 toward the inner side of the fins 43.

After resin has been filled into the mold 51 in this manner, the mold 51 is cooled. The mold 51 may be cooled naturally, or may be forcefully cooled by cycling cold water supplied from outside through a water-cooling pipe provided to the mold 51.

The resin filled into the mold 51 in the above-described manner is cooled and solidified to form the base 13 and the plural protrusions 14. Namely, the base 13 that encapsulates the thermoelectric element 31, the substrate 30, and the like is formed by the resin filled into the first cavity 53 of the first mold 52, and the protrusions 14 that support the fins 43 are formed by the resin filled into the inner side of the fins 43. The electronic device 10 manufactured under the above principles is taken out of the mold 51.

Next, explanation follows regarding operation and advantageous effects of the first exemplary embodiment.

As described in detail above, in the first exemplary embodiment, the molding in which the thermoelectric element 31, the substrate 30, and the like are encapsulated by the main body 12, and the adhesion of the heat dissipating sheet 40 to the main body 12, are performed by the same process. Accordingly, there are fewer manufacturing processes than in cases in which the molding process in which the thermoelectric element 31, the substrate 30, and the like are encapsulated by the main body 12, and the adhesion process of the heat dissipating sheet 40 to the main body 12 are performed as separate processes. This enables the cost of the electronic device 10 to be reduced.

Moreover, by employing the sheet-shaped heat dissipating sheet 40 for heat dissipation, the electronic device 10 can be made more compact compared to configurations provided with a heat dissipating member such as a cast or machined article for heat dissipation.

The main body 12 integrated with the heat dissipating sheet 40 encapsulates the thermoelectric element 31, the substrate 30, and the like, and the thermoelectric element 31, the substrate 30, and the like can therefore be protected by the main body 12.

Moreover, since plural bent fins 43 are formed in the heat dissipating sheet 40, the surface area of the heat dissipating sheet 40 can be increased by an amount corresponding to the plural fins 43 formed. This enables the heat dissipation performance of the heat dissipating sheet 40 to be improved.

Moreover, the protrusions 14 filled into the inner side of the fins 43 are formed in the main body 12, and the fins 43 are supported by the protrusions 14 from the inner side of the fins 43. Accordingly, the fins 43 can be suppressed from undergoing deformation such as crushing even when an external force is applied to the fins 43. This enables the heat dissipation performance of the heat dissipating sheet 40 to be maintained.

Next, explanation follows regarding example applications of the electronic device 10 according to the first exemplary embodiment.

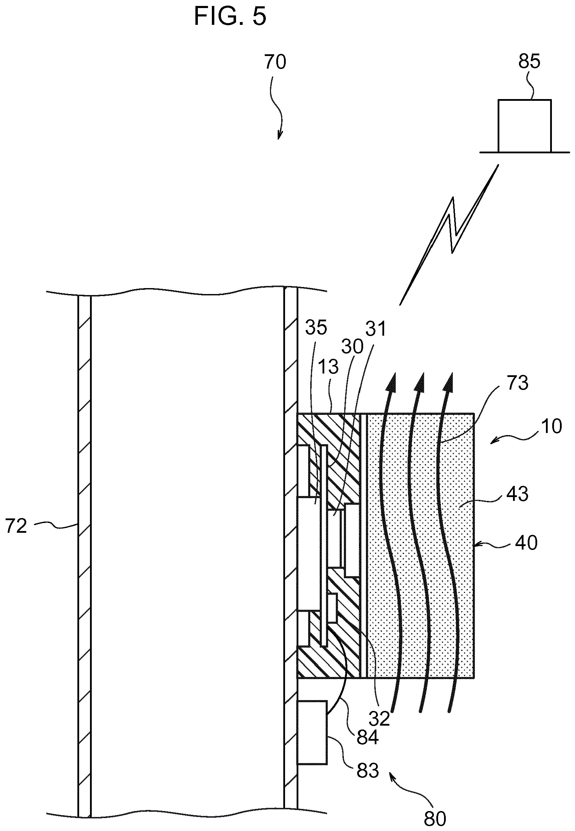

As an example, an information processing system 70 illustrated in Fig. 5 is a system for managing temperature data of a pipe 72 having high temperature fluid flowing therein. The information processing system 70 includes an integrated module 80 and a server 85.

The integrated module 80 is installed on a surface of the pipe 72, which is an example of an "installation target". The integrated module 80 includes the electronic device 10 described above, and a sensor 83. In the integrated module 80, the thermoelectric element 31 of the electronic device 10 is an example of a "power supply section", and the sensor 83 is an example of a "detector". The thermoelectric element 31 is thermally connected to the pipe 72 via the heat conducting member 35. The sensor 83 is, for example, a thermosensor and is fixed to the surface of the pipe 72. The sensor 83 is connected to the substrate 30 via wiring 84.

In the integrated module 80, the temperature of the heat absorbing face of the thermoelectric element 31 thermally connected to the pipe 72 rises when the high temperature fluid flows inner side the pipe 72. However, the temperature of the heat dissipating face of the thermoelectric element 31 thermally connected to the heat dissipating sheet 40 is lowered when the fins 43 are exposed to, for example, external air such as an air current 73. Thus, when a temperature difference arises between the heat absorbing face and the heat dissipating face of the thermoelectric element 31, power is generated by the thermoelectric element 31.

Packaged components, including the communication component 32 and the like, packaged on the substrate 30, and the sensor 83, operate using power generated by the thermoelectric element 31. The sensor 83 outputs signals in accordance with the surface temperature of the pipe 72, and the communication component 32 transmits the data detected by the sensor 83 to the server 85. The server 85 receives and accumulates data transmitted from the integrated module 80. Note that an operation lamp indicating the operational state of the communication component 32 or the like may be provided to the integrated module 80.

In the information processing system 70, data can be transmitted from the integrated module 80 even in environments ill-suited to human entry, such as those where the surroundings of the pipe 72 reach a high temperature due to heat emitted by the pipe 72, and those with high levels of dust and grime. This enables the temperature state of the pipe 72 to be ascertained based on the data transmitted from the integrated module 80.

Next, explanation follows regarding modified examples of the first exemplary embodiment.

Although the electronic device 10 is formed as the sensor node-type integrated module 80 combined with the sensor 83 in the first exemplary embodiment, the electronic device 10 may be employed in applications other than that described above.

Although the electronic device 10 includes the thermoelectric element 31 as an example of an "electronic component", electronic components other than the thermoelectric element 31 may be included.

Although the main body 12 is formed using polyamide resin as an example of a "first material", the main body 12 may be formed from a resin other than polyamide resin.

Although the heat dissipating sheet 40 is formed using graphite as an example of a "second material", as long as this material has higher thermal conductivity than the material forming the main body 12, the heat dissipating sheet 40 may be formed from, for example, a metal such as aluminum or copper, or may be formed from a material other than a metal.

Although each of the fins 43 has a pointed shape (an isosceles triangle-shaped cross-section) that narrows in width on progression toward the apex 43A, the fins 43 may have another cross-section profile, such as a rectangle-shaped cross-section.

Although the electronic device 10 includes the thermoelectric element 31, the connecting member 33, the heat spreader 34, the heat conducting member 35, the substrate 30, and the heat dissipating component 50 integrated together in the first exemplary embodiment, the heat dissipating component 50 may be independent from the device body of the electronic device 10.

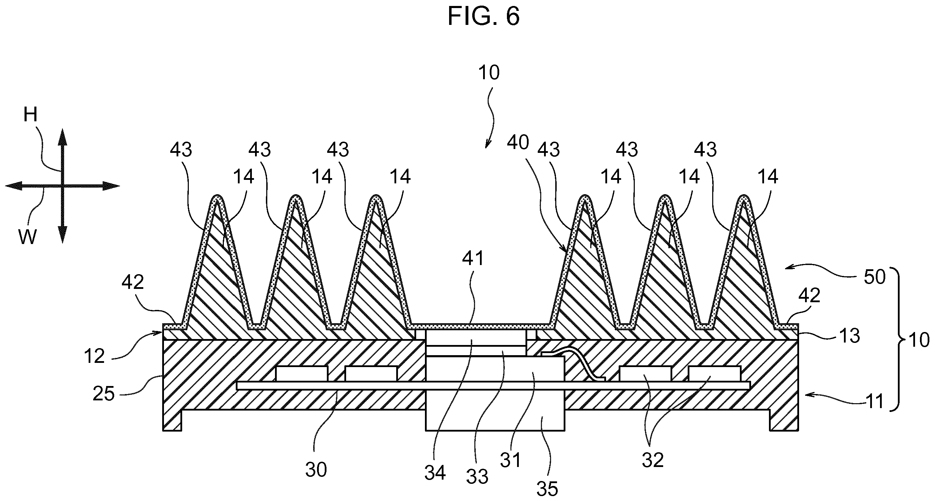

For example, in the modified example illustrated in Fig. 6, a device body 11 is formed by the thermoelectric element 31, the connecting member 33, the heat spreader 34, the heat conducting member 35, the substrate 30, and an encapsulating resin 25 that encapsulates these components. The heat dissipating component 50 includes the main body 12 and the heat dissipating sheet 40, and is formed independently from the device body 11. In the modified example illustrated in Fig. 6, the heat dissipating component 50 is a molded article, and the heat dissipating component 50 can be provided at low cost, enabling the cost of the electronic device 10 to be reduced.

According to the first exemplary embodiment illustrated in Fig. 5, in the integrated module 80, the electronic device 10 may include a battery that stores power generated by the thermoelectric element 31. In such cases, the thermoelectric element 31 and the battery correspond to an example of a "power supply section". Moreover, the sensor 83 and the communication component 32 may operate using power from at least one out of the thermoelectric element 31 or the battery.

The information processing system 70 may be employed in applications other than the management of temperature data of the pipe 72 having high temperature fluid flowing therein.

### Second Exemplary Embodiment that forms part of the invention

Next, explanation follows regarding a second exemplary embodiment according to technology disclosed herein.

In the second exemplary embodiment, the manufacturing method differs as follows from the manufacturing method for an electronic device according to the first exemplary embodiment described above. In the second exemplary embodiment, the electronic device is manufactured under the following principles.

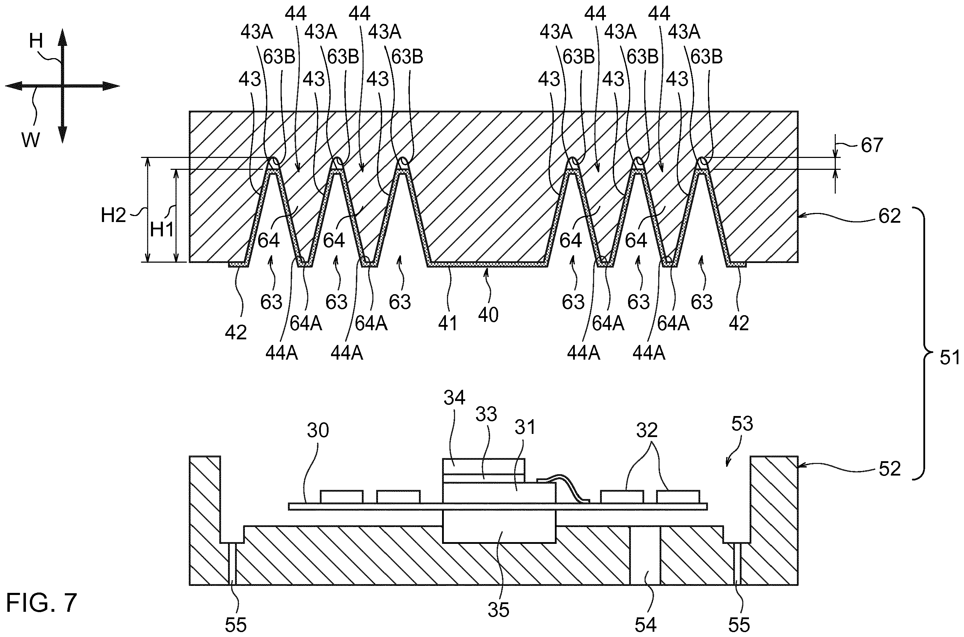

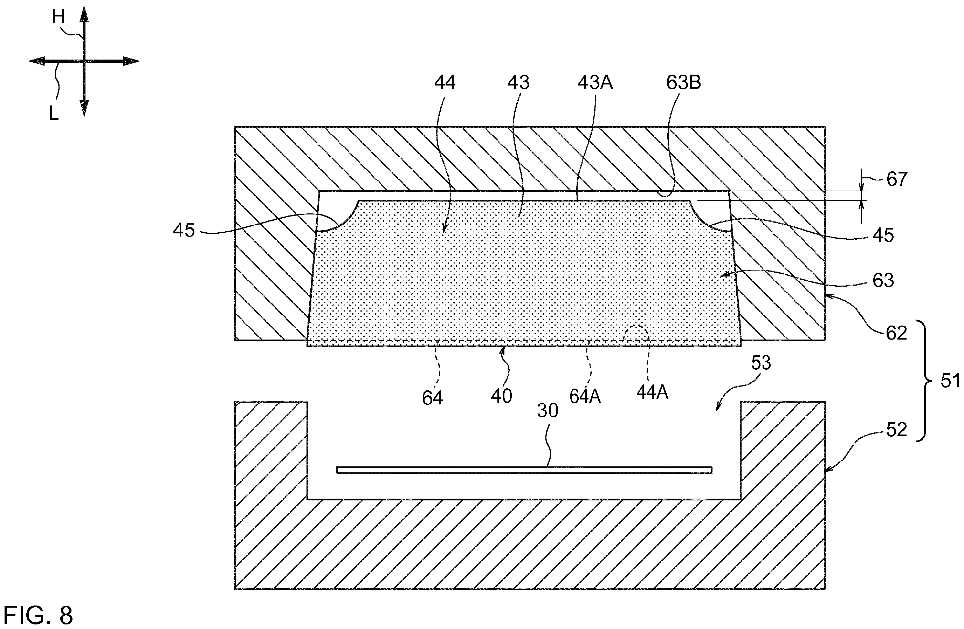

First, as illustrated in Fig. 7 and Fig. 8, the substrate 30 is housed in the first cavity 53 inner side the first mold 52, and the heat dissipating sheet 40 is housed in the second cavities 63 inner side the second mold 62.

As illustrated in Fig. 7, the heat dissipating sheet 40 is pre-formed such that a height HI of the fins 43 in the height H direction is lower than a depth H2 of the second cavities 63. Then, in a state in which the heat dissipating sheet 40 is housed inner side the second cavities 63, gaps 67 are formed between the apexes 43A of the fins 43 and the bottom faces 63B of the second cavities 63.

Moreover, as illustrated in Fig. 8, cut-outs 45, which are examples of a "communication port", are pre-formed in length L direction end portions of the apexes 43A of the fins 43. The cut-outs 45 are formed when the heat dissipating sheet 40 is pressed. The cut-outs 45 penetrate through the thickness direction of the apexes 43A, and place the inner side of the fins 43 in communication with the gaps 67 between the apexes 43A of the fins 43 and the bottom faces 63B of the second cavities 63. The cut-outs 45 are each cut out in a circular arc shape as an example.

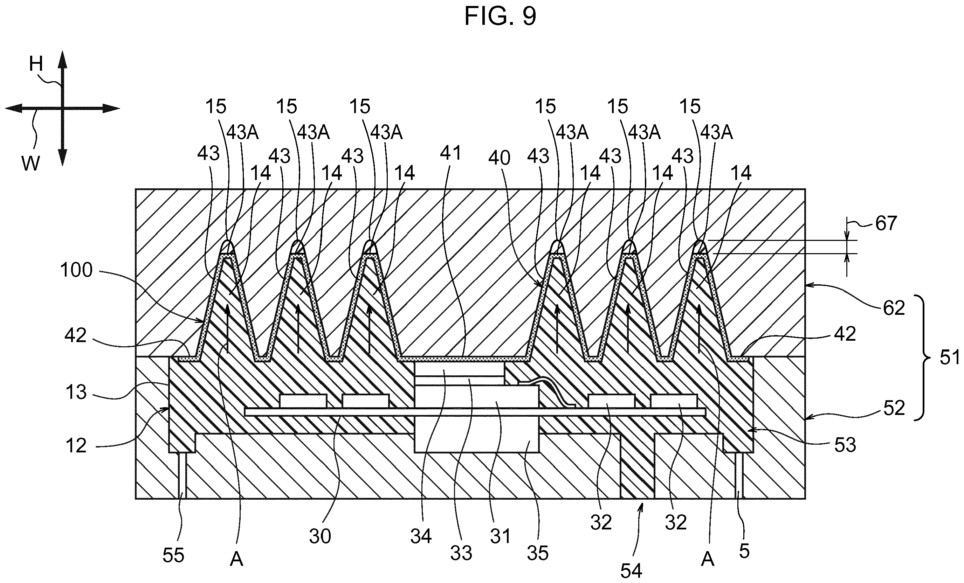

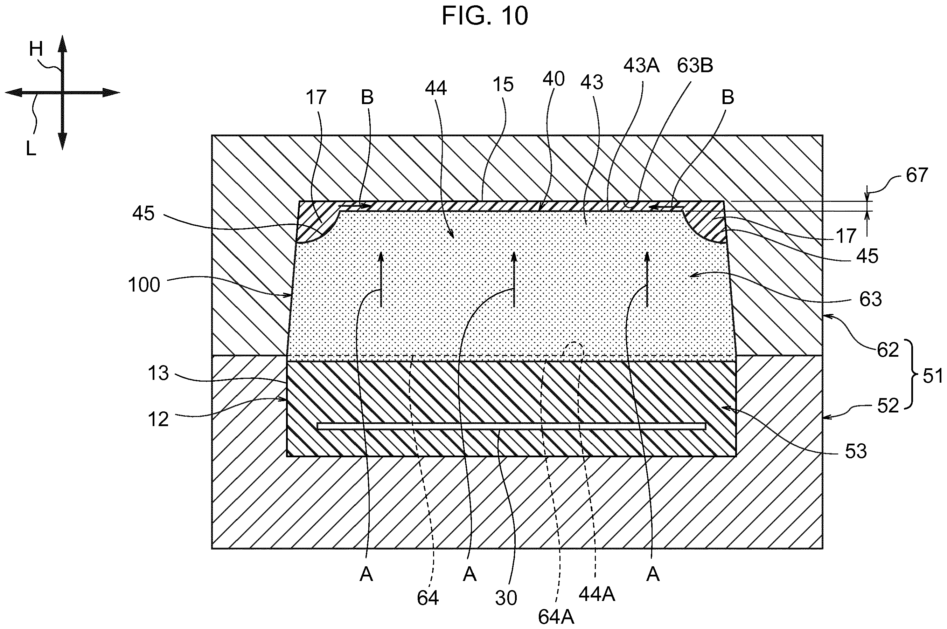

Then, in a state in which the heat dissipating sheet 40 and the substrate 30 are thus set up in the mold 51, the first mold 52 and the second mold 62 are assembled together. Next, as illustrated in Fig. 9, resin, which is an example of a "first material", is injected through the injection port 54 into the mold 51 in a molten state. The resin injected into the mold 51 flows from the inner side of the fins 43 toward the apexes 43A of the fins 43 as indicated by the arrows A in Fig. 9 and Fig. 10, and is filled into the inner side of the fins 43. The fins 43 bulge and make close contact with the inner faces of the second cavities 63 due to the resin being filled into the inner side of the fins 43.

Resin that has reached the apexes 43A of the fins 43 rebounds off the apexes 43A and flows to the end portions inner side the fins 43 at both length L direction sides thereof. The resin that has flowed to the end portions inner side the fins 43 at both length L direction sides thereof passes through the cut-outs 45 and is filled into the gaps 67 between the apexes 43A of the fins 43 and the bottom faces 63B of the second cavities 63 as indicated by the arrows B in Fig. 10.

Then, the resin filled into the mold 51 as described above is cooled and solidified to form the base 13, the plural protrusions 14, and plural protection portions 15 as illustrated in Fig. 9. Namely, the base 13 that encapsulates the thermoelectric element 31, the substrate 30, and the like is formed by the resin filled into the first cavity 53 of the first mold 52, and the protrusions 14 that support the fins 43 are formed by the resin filled into the inner side of the fins 43. Moreover, the protection portions 15 that cover the apexes 43A of the fins 43 are formed by the resin filled into the gaps 67 between the apexes 43A of the fins 43 and the bottom faces 63B of the second cavities 63.

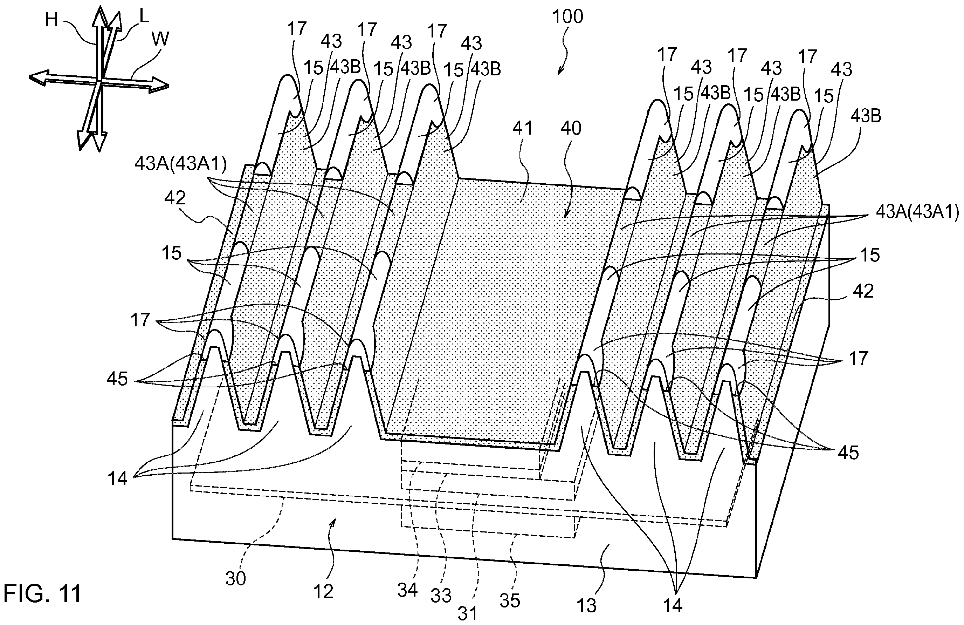

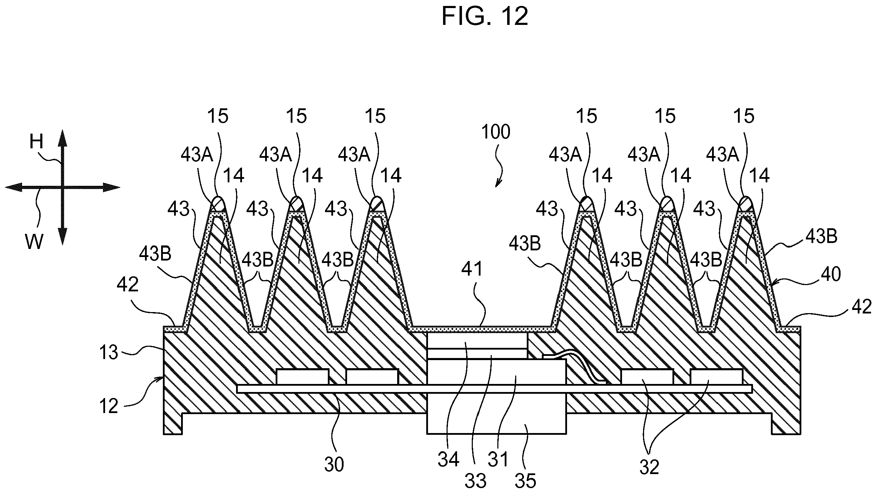

In the second exemplary embodiment, an electronic device 100 (see Fig. 11) is manufactured under the above principles. In the electronic device 100 thus manufactured, the protection portions 15 are formed on the apexes 43A of the fins 43 on both sides of length L direction central portions 43A1, and the length L direction central portions 43A1 of the apexes 43A of the fins 43 are exposed to the exterior. As illustrated in Fig. 11 and Fig. 12, the protection portions 15 are provided on the apex 43A sides of the fins 43, and portions of side face portions 43B of the fins 43 on the base end portion sides of the fins 43 with respect to the protection portions 15 are exposed to the exterior.

As illustrated in Fig. 11, the main body 12 and the protection portions 15 are integrally formed through coupling portions 17 formed in the cut-outs 45. Moreover, the main body 12 and the protection portions 15 are made of resin and are integrated with the heat dissipating sheet 40 by molding.

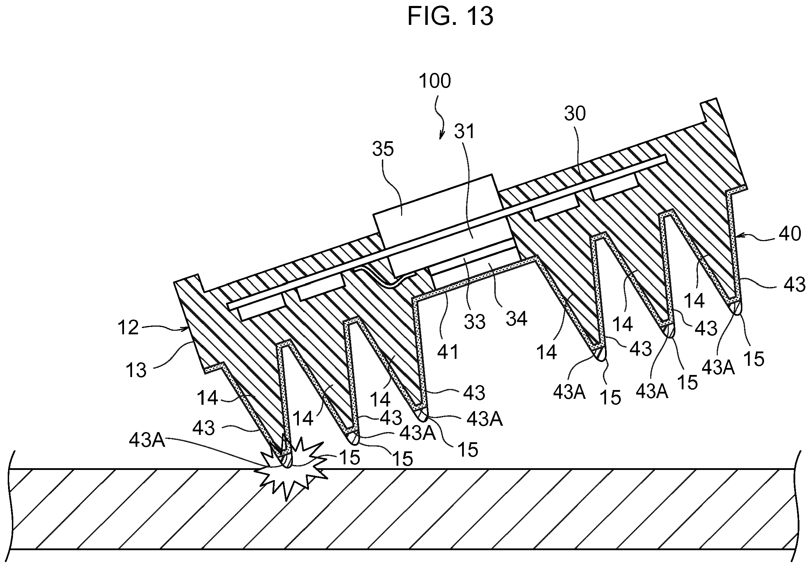

According to the second exemplary embodiment, the protection portions 15 that cover the apexes 43A are formed on the apexes 43A of the fins 43. Accordingly, as illustrated in Fig. 13, even if, for example, the electronic device 100 were to fall to the floor, damage to the apexes 43A of the fins 43 due to hitting the floor can be suppressed. This enables the heat dissipation performance of the heat dissipating sheet 40 to be maintained.

As illustrated in Fig. 11 and Fig. 12, the protection portions 15 are provided on the apex 43A sides of the fins 43, and portions of the side face portions 43B of the fins 43 on the base end portion sides of the fins 43 with respect to the protection portions 15 are exposed to the exterior. Accordingly, since heat in the heat dissipating sheet 40 is dissipated at the portions of the side face portions 43B of the fins 43 on the base end portion sides of the fins 43 with respect to the covering portions protection portions 15, the heat dissipation performance of the heat dissipating sheet 40 can be secured. Namely, although heat dissipation from the apexes 43A is suppressed by covering the apexes 43A with the protection portions 15, since the surface area of the apexes 43A is less than the surface area of the side face portions 43B of the fins 43, the influence that providing the protection portions 15 has on the heat dissipation performance of the heat dissipating sheet 40 can be suppressed.

As illustrated in Fig. 11, the protection portions 15 are formed at the apexes 43A of the fins 43 on both sides of the length L direction central portions 43A1, and the length L direction central portions 43A1 of the apexes 43A of the fins 43 are exposed to the exterior. This accordingly enables the heat dissipation performance of the heat dissipating sheet 40 to be improved by an amount corresponding to the exposure of the length L direction central portions 43A1 of the apexes 43A of the fins 43 to the exterior.

The main body 12 and the protection portions 15 are integrally formed by molding. Likewise, this enables the cost of the electronic device 10 to be reduced compared to cases in which, for example, the main body 12 and the protection portions 15 are formed separately, since there are fewer manufacturing processes.

Although the cut-outs 45 of the heat dissipating sheet 40 are cut out in circular arc shapes in the second exemplary embodiment, a shape other than a circular arc may be cut out.

In the second exemplary embodiment, resin may be filled into the gaps 67 so as to span across the entire lengths of the gaps 67 by adjusting, for example, the gaps 67 between the apexes 43A of the fins 43 and the bottom faces 63B of the second cavities 63, or the pressure and amount of resin to be filled into the gaps 67. The protection portions 15 may be formed over the entirety of the apexes 43A by the resin filled into the gaps 67.

### Third Exemplary Embodiment that forms part of the invention

Next, explanation follows regarding a third exemplary embodiment of technology disclosed herein.

In the third exemplary embodiment, the manufacturing method differs as follows from the manufacturing method for an electronic device according to the second exemplary embodiment, described above.

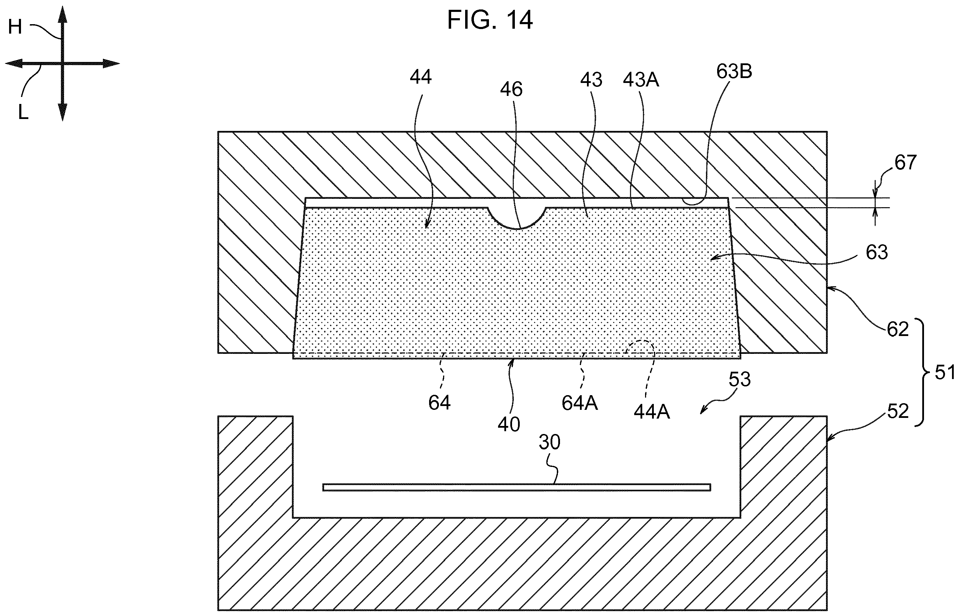

As illustrated in Fig. 14, in the manufacturing method for an electronic device according to the third exemplary embodiment, holes 46, which are examples of a "communication port", are pre-formed in the apexes 43A of the fins 43, instead of the cut-outs 45 (see Fig. 8) described above. The holes 46 are formed when the heat dissipating sheet 40 is pressed. The holes 46 penetrate the thickness direction of the apexes 43A, and place the inner side of the fins 43 in communication with the gaps 67 between the apexes 43A of the fins 43 and the bottom faces 63B of the second cavities 63. The holes 46 are each cut out in a circular arc shape as an example.

In the third exemplary embodiment, in a state in which the heat dissipating sheet 40 and the substrate 30 are set up in the mold 51, the first mold 52 and the second mold 62 are assembled together, similarly to in the first exemplary embodiment and the second exemplary embodiment described above.

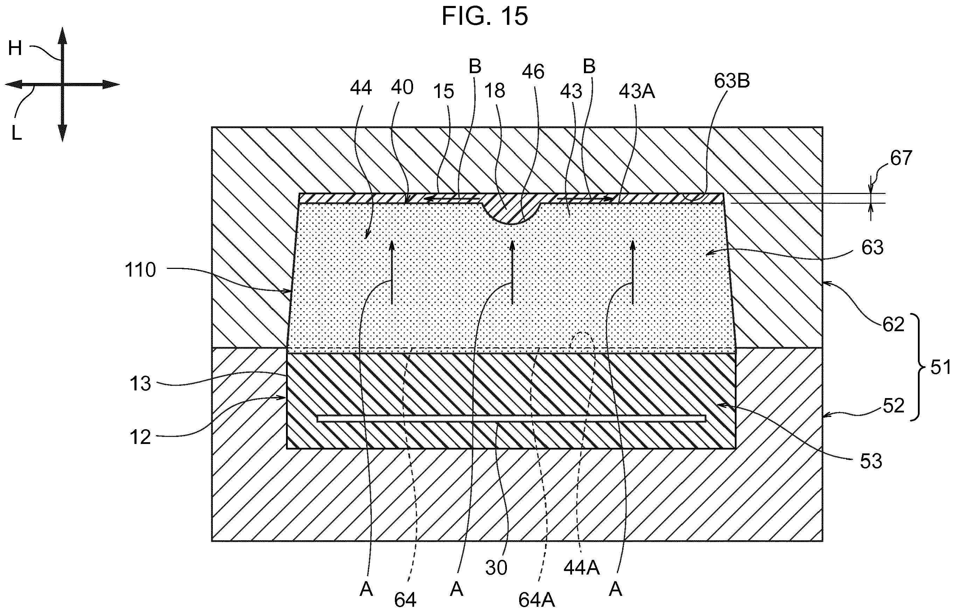

Next, as illustrated in Fig. 15, resin, which is an example of a "first material", is injected into the mold 51 in a molten state. The resin injected into the mold 51 flows from the inner side of the fins 43 toward the apexes 43A of the fins 43 as indicated by the arrows A in Fig. 15, and is filled into the inner side of the fins 43. The fins 43 bulge and make close contact with the inner faces of the second cavities 63 due to resin being filled into the inner side of the fins 43. The resin inner side the fins 43 passes through the holes 46 and fills into the gaps 67 between the apexes 43A of the fins 43 and the bottom faces 63B of the second cavities 63, as indicated by the arrows B in Fig. 15.

Then, resin filled into the mold 51 as described above is cooled and solidified to form the base 13, the plural protrusions 14, and the plural protection portions 15, similarly to in the second exemplary embodiment.

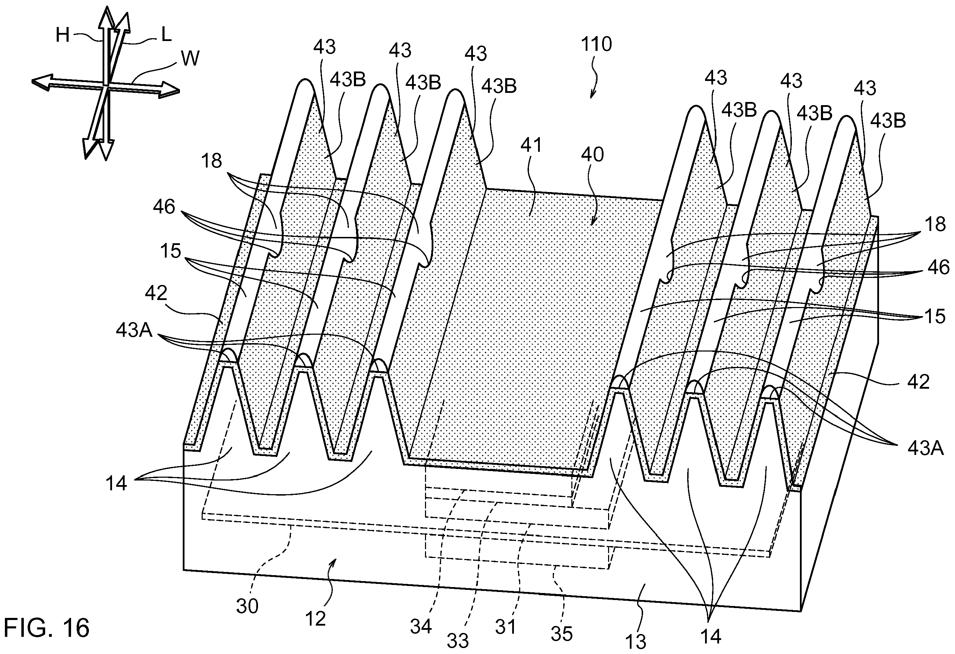

In the third exemplary embodiment, an electronic device 110 (see Fig. 16) is manufactured under the above principles. In the electronic device 110 thus manufactured, the protection portions 15 are formed over the entirety of the apexes 43A, including the length L direction central portions of the apexes 43A of the fins 43. The protection portions 15 are provided to the apexes 43A sides of the fins 43, and portions of the side face portions 43B of the fins 43 on the base end portion sides of the fins 43 with respect to the protection portions 15 are exposed to the exterior.

The main body 12 and the protection portions 15 are integrally formed through coupling portions 18 formed in the holes 46. The main body 12 and the protection portions 15 are made of resin, and are integrated with the heat dissipating sheet 40 by molding.

The protection portions 15 that cover the apexes 43A are formed on the apexes 43A of the fins 43 in the third exemplary embodiment as well. Accordingly, even if, for example, the electronic device 110 were to fall to the floor, damage to the apexes 43A of the fins 43 due to hitting the floor can be suppressed. This enables the heat dissipation performance of the heat dissipating sheet 40 to be maintained.

In particular, in the third exemplary embodiment, the protection portions 15 extend along the length L direction so as to entirely cover the apexes 43A, thereby enabling damage to the apexes 43A to be suppressed across the entirety of the apexes 43A.

Moreover, the protection portions 15 are provided on the apex 43A sides of the fins 43, and portions of the side face portions 43B of the fins 43 on the base end portion sides of the fins 43 with respect to the protection portions 15 are exposed to the exterior. Accordingly, since heat in the heat dissipating sheet 40 is dissipated at the portions of the side face portions 43B of the fins 43 on the base end portion sides of the fins 43 with respect to the protection portions 15, the heat dissipation performance of the heat dissipating sheet 40 can be secured.

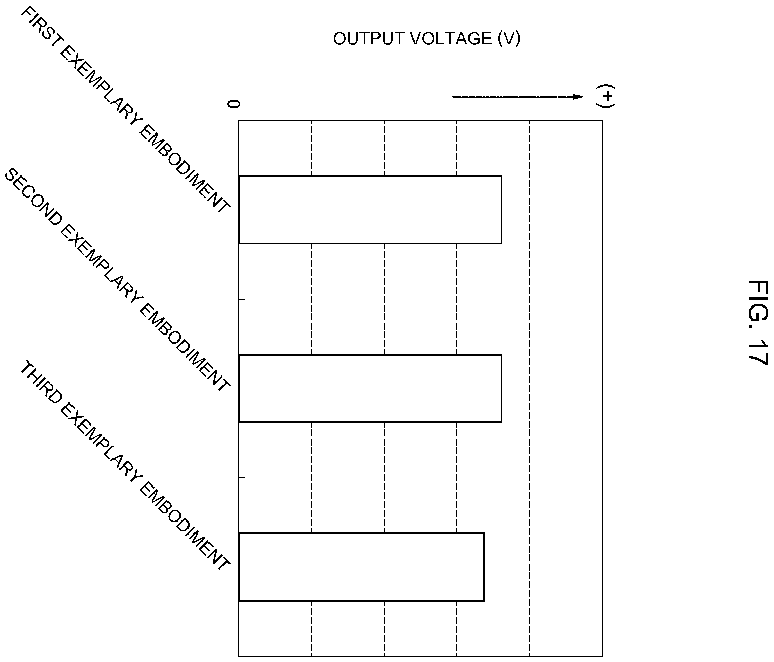

Fig. 17 illustrates a comparison between output voltages of an electronic device according to the first exemplary embodiment, an electronic device according to the second exemplary embodiment, and an electronic device according to the third exemplary embodiment described above. The output voltages depend on the thermoelectric element 31 (see Fig. 1, Fig. 11, and Fig. 16). In each of the electronic devices, the heat dissipation performance of the heat dissipating sheet is secured, and the output voltages are substantially similar to each other.

Although the holes 46 of the heat dissipating sheet 40 are cut out in circular arc shapes in the third exemplary embodiment, a shape other than a circular arc may be cut out.

Moreover, in the third exemplary embodiment, resin may be filled into length L direction central portions of the gaps 67 (portions surrounding the holes 46) by adjusting, for example, the gaps 67 between the apexes 43A of the fins 43 and the bottom faces 63B of the second cavities 63, or the pressure and amount of resin to be filled into the gaps 67. The protection portions 15 may be formed on the length L direction central portions of the apexes 43A by the resin filled in the length L direction central portions of the gaps 67.

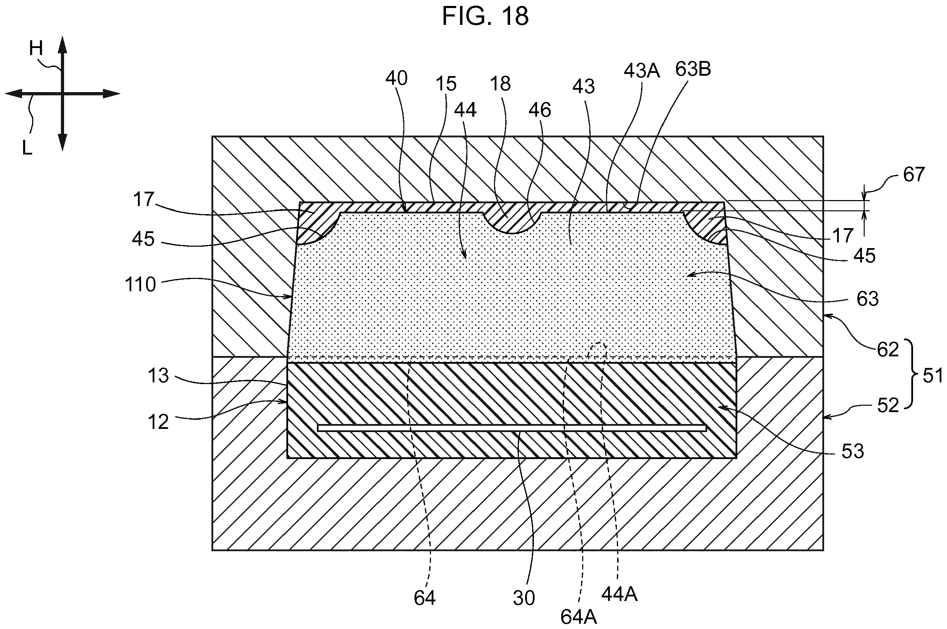

As illustrated in Fig. 18, in addition to the holes 46 described above, the cut-outs 45 of the second exemplary embodiment may also be formed in the apexes 43A of the fins 43.

### Fourth Exemplary Embodiment that forms part of the invention

Next, explanation follows regarding a fourth exemplary embodiment according to technology disclosed herein.

In the fourth exemplary embodiment, the manufacturing method differs as follows from the manufacturing method for an electronic device according to the second exemplary embodiment, described above.

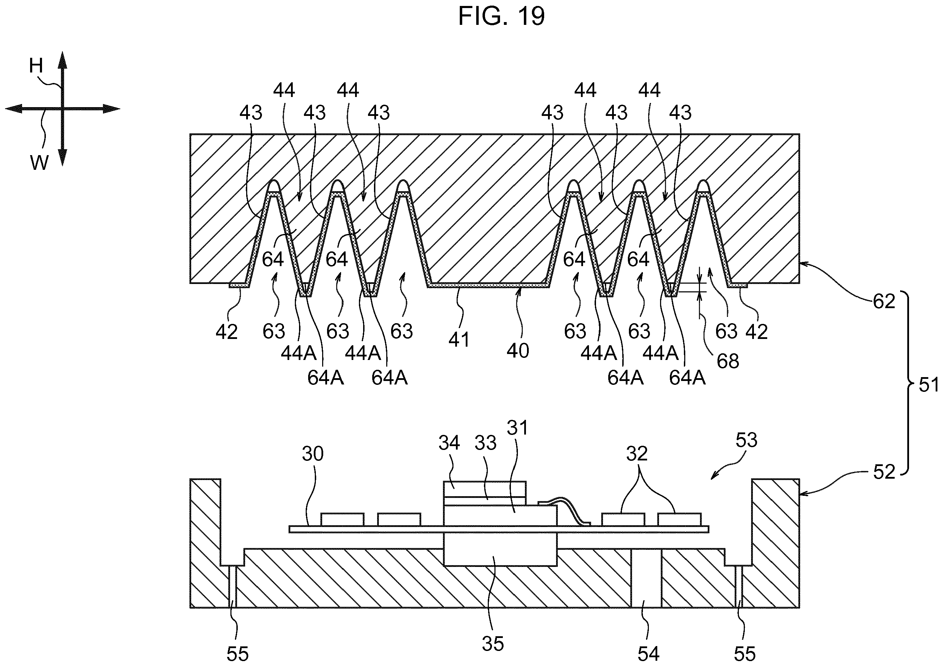

As illustrated in Fig. 19, the bottom portions 44A of the grooves 44 formed in the heat dissipating sheet 40 are at a lower position in the depth direction of the grooves 44 (the height H direction) than the connecting portion 41 and the edge portions 42. In a state in which the heat dissipating sheet 40 is attached to the second mold 62, gaps 68 are formed between the leading end portions 64A of the projections 64 inserted into the grooves 44 and the bottom portions 44A.

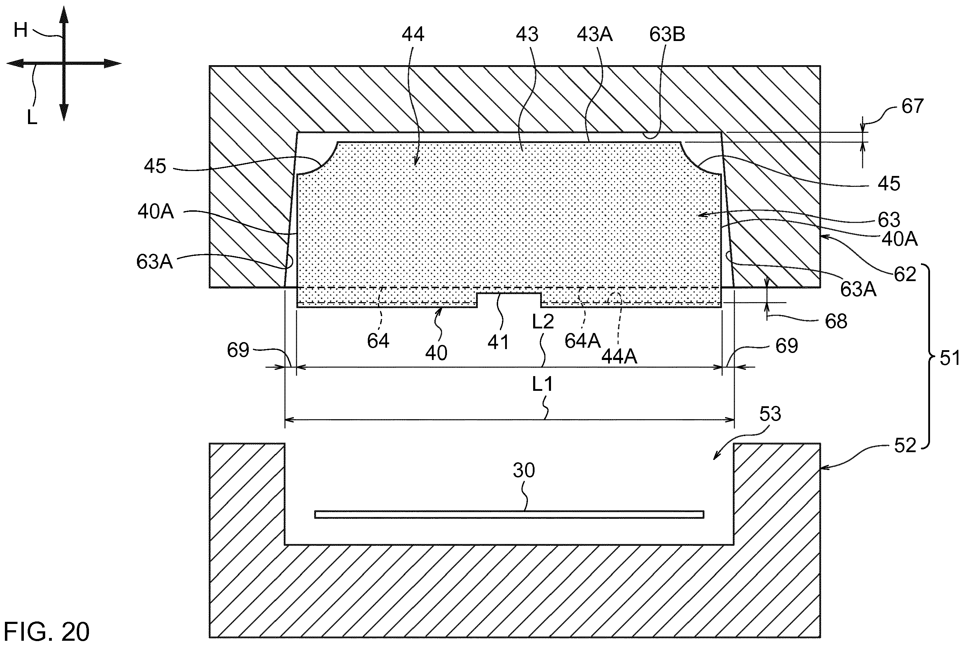

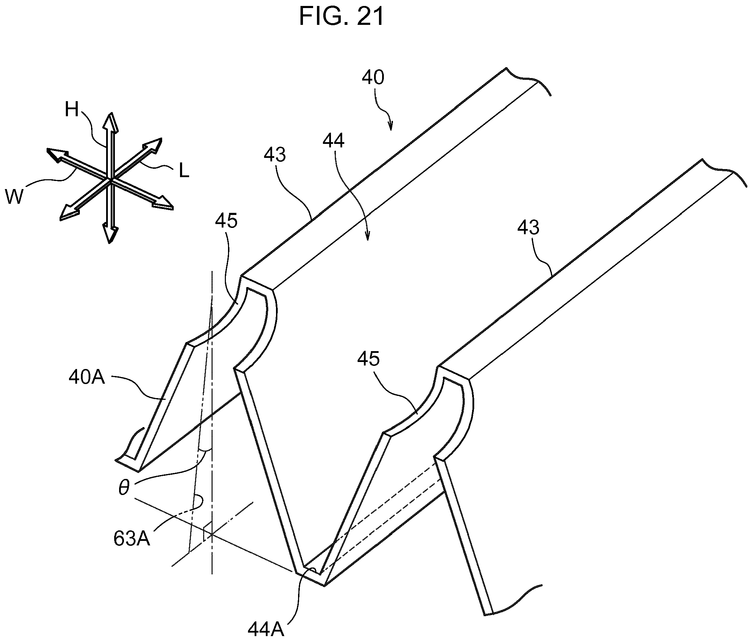

As illustrated in Fig. 20, length L direction end portions 40A of the heat dissipating sheet 40 extend in a straight line along the height H direction in a state in which the heat dissipating sheet 40 is attached to the second mold 62. In contrast thereto, length L direction side faces 63A of the second cavities 63 are inclined with respect to the height H direction so as to slope out toward respective end sides of the second cavities 63 in the length L direction on progression toward the height H direction lower side. Namely, as illustrated in Fig. 21, the side faces 63A in the length L direction of the second cavities 63 have an inclination angle θ with respect to the height H direction. The inclination angle θ (taper) of the second cavities 63 is provided to facilitate removal of molded articles from the second cavities 63.

As illustrated in Fig. 20, due to the incline of the side faces 63A of the second cavities 63, a length L2 of the heat dissipating sheet 40 in the length L direction is shorter than a length L1 of the first cavity 53 and the second cavities 63 in the length L direction for forming the main body 12. The length L1 of the second cavities 63 in the length L direction is equivalent to the opening width at the first mold 52 side of the second cavities 63 and the opening width at the second mold 62 side of the first cavity 53.

In the fourth exemplary embodiment, in a state in which the heat dissipating sheet 40 and the substrate 30 are set up in the mold 51, the first mold 52 and the second mold 62 are assembled together, similarly to in the second exemplary embodiment described above.

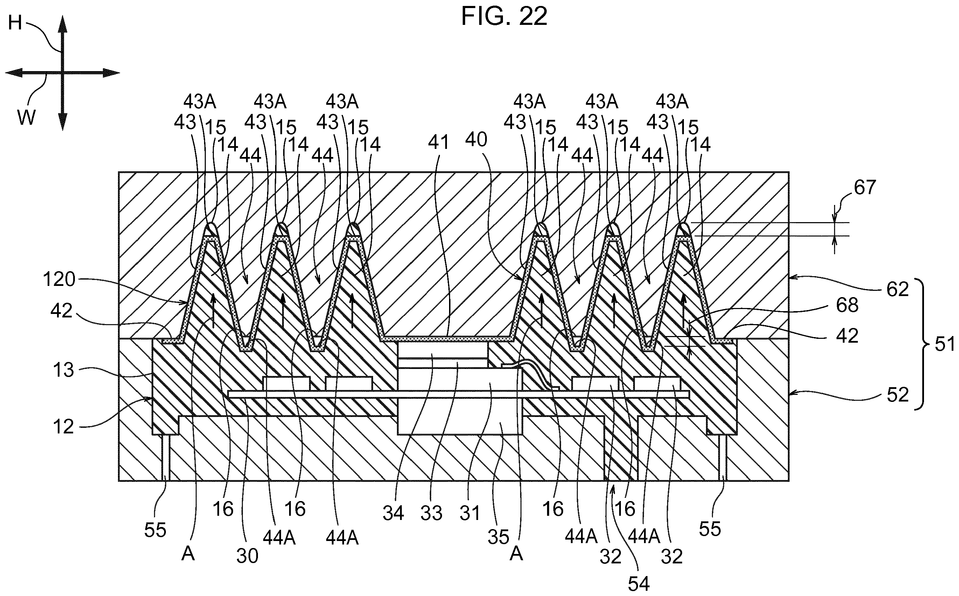

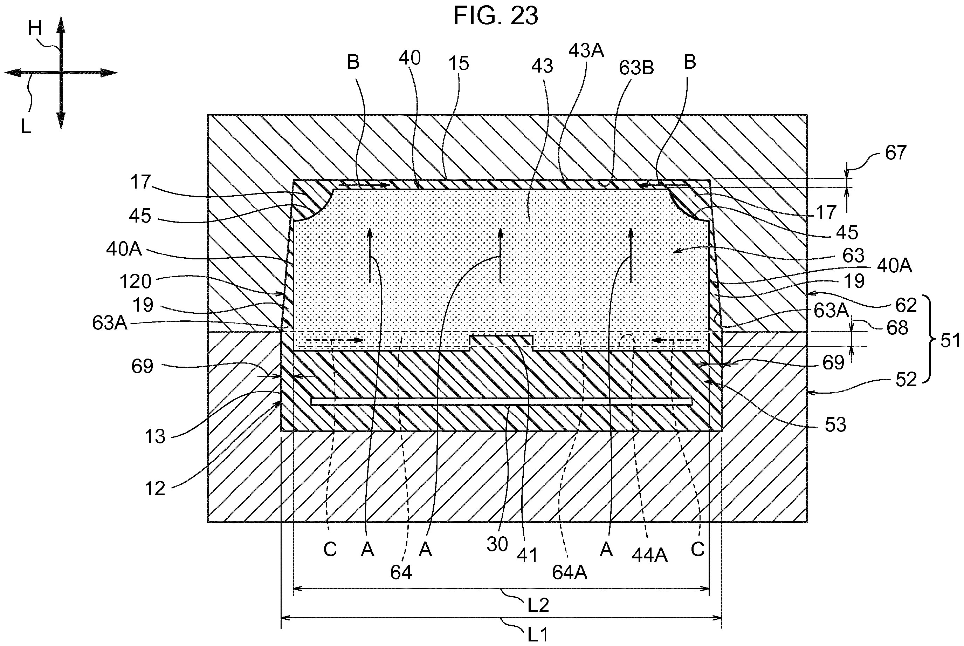

Next, as illustrated in Fig. 22, resin, which is an example of a "first material", is injected in a molten state into the mold 51, toward the inner side of the fins 43. The resin injected into the mold 51 flows from the inner side of the fins 43 toward the apexes 43A of the fins 43 as indicated by the arrows A in Fig. 22 and Fig. 23, and is filled into the inner side of the fins 43. The fins 43 bulge and make close contact with the inner faces of the second cavities 63 due to the resin being filled into the inner side of the fins 43.

Resin that has reached the apexes 43A of the fins 43 rebounds off the apexes 43A and flows to the end portions inner side the fins 43 at both length L direction sides thereof. Some of the resin that has flowed to the end portions inner side the fins 43 at both length L direction sides thereof passes through the cut-outs 45 and fills into the gaps 67 between the apexes 43A of the fins 43 and the bottom faces 63B of the second cavities 63, as indicated by the arrows B in Fig. 23.

The rest of the resin that has flowed to the end portions at both length L direction sides of the fins 43 flows out to the outside of the fins 43 through the openings inner side the fins 43 at both length L direction sides thereof. The resin that has flowed out to the outside of the fins 43 passes through gaps 69 between the length L direction end portions 40A of the heat dissipating sheet 40 and the side faces 63A of the second cavities 63 and fills into the gaps 68 between the leading end portions 64A of the projections 64 and the bottom portions 44A as indicated by the arrows C in Fig. 23.

Then, as illustrated in Fig. 22, the resin filled into the mold 51 as described above is cooled and solidified to form the base 13, the plural protrusions 14, the plural protection portions 15, and plural covering portions 16. As illustrated in Fig. 22 and Fig. 23, the protection portions 15 are formed by the resin filled into the gaps 67 between the apexes 43A of the fins 43 and the bottom faces 63B of the second cavities 63, and the covering portions 16 are formed by the resin filled into the gaps 68 between the leading end portions 64A of the projections 64 and the bottom portions 44A.

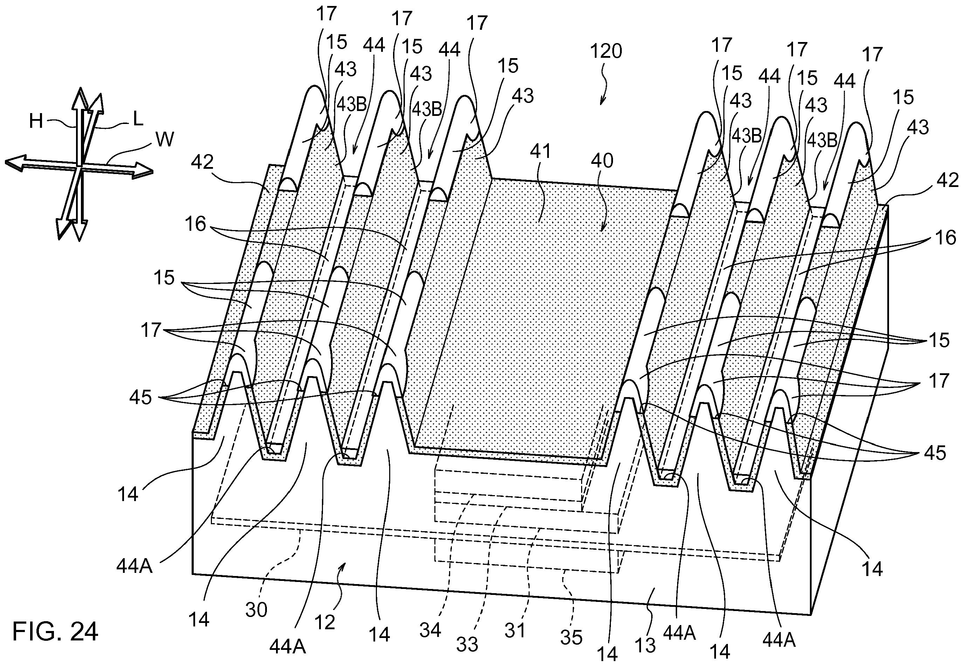

In the fourth exemplary embodiment, an electronic device 120 (see Fig. 24) is manufactured under the above principles. In the electronic device 120 thus manufactured, the covering portions 16 entirely cover the bottom portions 44A of the grooves 44 formed between the plural fins 43. Moreover, coupling portions 19 (see Fig. 23) are formed to the main body 12 during molding. The coupling portions 19 cover both length L direction sides of the heat dissipating sheet 40, and extend from the main body 12 toward the apexes 43A of the fins 43. The main body 12, the protection portions 15, and the covering portions 16 are integrally formed through the coupling portions 19. In Fig. 24, illustration of the coupling portions 19 (see Fig. 23) is omitted in order to facilitate understanding of the internal structure of the electronic device 120.

The main body 12, the protection portions 15, and the covering portions 16 are made of resin, and are integrated with the heat dissipating sheet 40 by molding. The covering portions 16 are formed in long, thin plate shapes and are provided to the bottom portion 44A sides of the grooves 44. Portions of the side face portions 43B of the fins 43 between the covering portions 16 and the protection portions 15 are exposed to the exterior due to the covering portions 16 being thinly formed.

As illustrated in Fig. 23, the length of the main body 12, including the coupling portions 19, in the length L direction is similar to the length L1 of the first cavity 53 and the second cavities 63 in the length L direction. The length L1 of the main body 12 in the length L direction is longer than the length L2 of the heat dissipating sheet 40 in the length L direction by an amount corresponding to the coupling portions 19 formed to the main body 12.

As illustrated in Fig. 24, the bottom portions 44A of the grooves 44 are covered by the covering portions 16 in the electronic device 120 according to the fourth exemplary embodiment. Accordingly, even when, for example, foreign matter that has collected in the grooves 44 is removed using a cleaning tool such as a brush, contact between the cleaning tool and the bottom portions 44A is prevented, enabling damage to the surface of the bottom portions 44A to be suppressed. This enables reduction of the heat dissipation performance of the heat dissipating sheet 40 to be suppressed even when the heat dissipating sheet 40 is formed from, for example, a soft, easily damaged material.

In particular, damage to the surface of the bottom portions 44A can be suppressed across the entirety of each bottom portion 44A since the covering portions 16 cover the entirety of each bottom portion 44A. This enables a reduction of the heat dissipation performance of the heat dissipating sheet 40 to be more effectively suppressed.

Moreover, the covering portions 16 are provided at the bottom portion 44A sides in the grooves 44, and portions of the side face portions 43B of the fins 43 between the covering portions 16 and the protection portions 15 are exposed to the exterior. Accordingly, since heat in the heat dissipating sheet 40 is dissipated at the portions of the side face portions 43B of the fins 43 between the covering portions 16 and the protection portions 15, the heat dissipation performance of the heat dissipating sheet 40 can be secured. Namely, although heat dissipation from the bottom portions 44A is suppressed by covering the bottom portions 44A with the covering portions 16, since the surface area of the bottom portions 44A is less than the surface area of the side face portions 43B of the fins 43, the influence that providing the covering portions 16 has on the heat dissipation performance of the heat dissipating sheet 40 can be suppressed.

The main body 12, the protection portions 15, and the covering portions 16 are integrally formed by the molding. Likewise, this enables the cost of the electronic device 120 to be reduced compared to cases in which, for example, the main body 12, the protection portions 15, and the covering portions 16 are formed separately, since there are fewer manufacturing processes.

In the fourth exemplary embodiment, the covering portions 16 cover the entirety of the bottom portions 44A. However, the covering portions 16 may be configured with a size and shape that only partially covers the bottom portions 44A.

### Fifth Exemplary Embodiment

Next, explanation follows regarding a fifth exemplary embodiment according to technology disclosed herein.

In the fifth exemplary embodiment, the manufacturing method differs as follows from the manufacturing method for an electronic device according to the fourth exemplary embodiment described above. In the fifth exemplary embodiment, the electronic device is manufactured under the following principles.

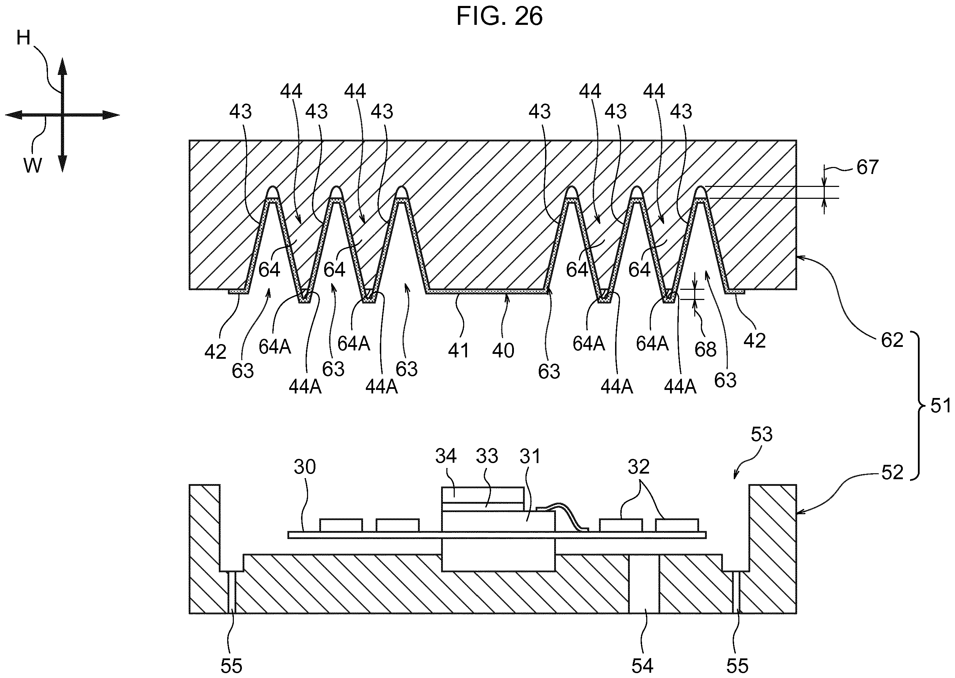

First, as illustrated in Fig. 26, the substrate 30 is housed in the first cavity 53 inner side the first mold 52, and the heat dissipating sheet 40 is housed in the second cavities 63 inner side the second mold 62.

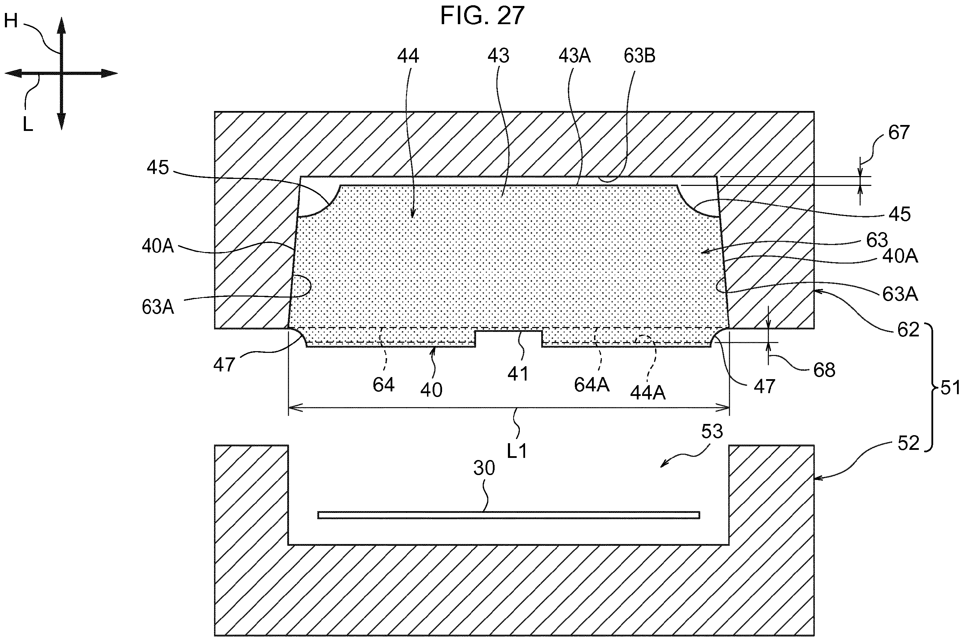

As illustrated in Fig. 27, the heat dissipating sheet 40 is pre-formed so as to have a length along the length L direction that is equal to the length L1 of the first cavity 53 and the second cavities 63 in the length L direction. Namely, in the fifth exemplary embodiment, the length L direction end portions 40A of the heat dissipating sheet 40 are inclined with respect to the height H direction so as to slope out toward the length L direction end sides on progression toward the height H direction lower side. Then, in a state in which the heat dissipating sheet 40 is attached to the second mold 62, the length L direction end portions 40A of the heat dissipating sheet 40 extend in a straight line along the side faces 63A in the length L direction of the second cavities 63.

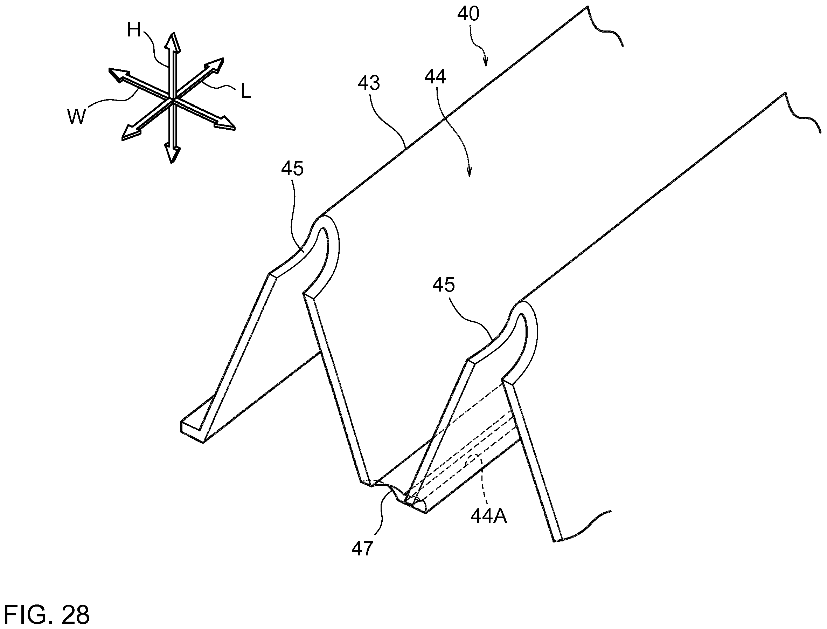

Moreover, the bottom portions 44A are formed in flat shapes, and are positioned at lower positions than the lower faces of the second mold 62. As illustrated in Fig. 27 and Fig. 28, cut-outs 47, which are examples of an "inflow port", are pre-formed in both length direction side end portions of each bottom portion 44A of the heat dissipating sheet 40. The cut-outs 47 are formed when the heat dissipating sheet 40 is pressed. The cut-outs 47 penetrate through the thickness direction of the bottom portions 44A, and place the inner side of the fins 43 in communication with the grooves 44. The cut-outs 47 are each cut out in a circular arc shape as an example.

As illustrated in Fig. 26, the bottom portions 44A are positioned at a lower position in the depth direction of the grooves 44 (the height H direction) than the leading end portions 64A of the projections 64 of the second mold 62 that are inserted into the grooves 44, and the gaps 68 are formed between the leading end portions 64A of the projections 64 and the bottom portions 44A. Then, in a state in which the heat dissipating sheet 40 and the substrate 30 are thus set up in the mold 51, the first mold 52 and the second mold 62 are assembled and fixed together.

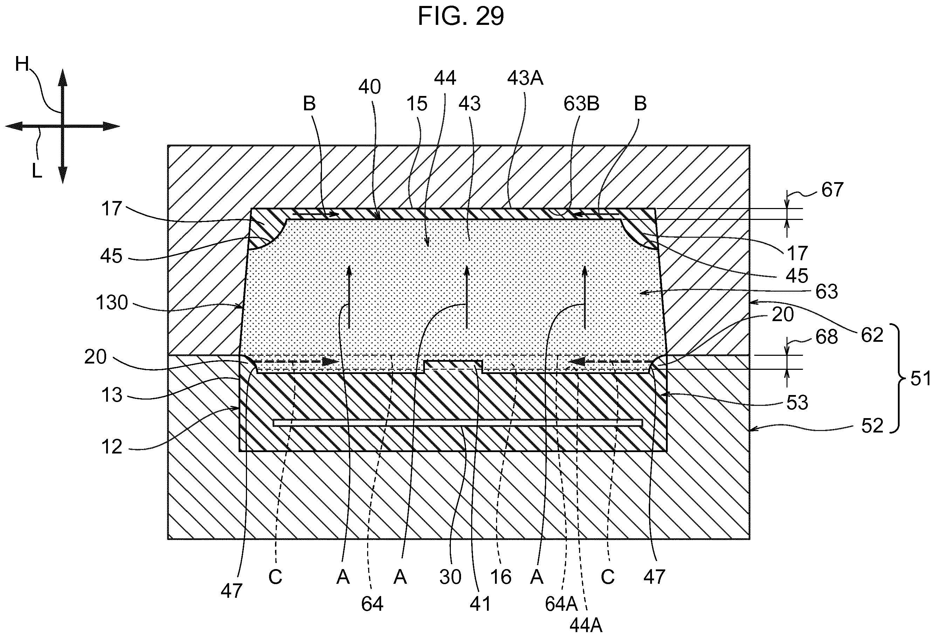

Next, as illustrated in Fig. 29, resin, which is an example of a "first material", is injected into the mold 51 in a molten state. The resin injected into the mold 51 flows from the inner side of the fins 43 toward the apexes 43A of the fins 43 as indicated by the arrows A in Fig. 29, and is filled into the inner side of the fins 43. The fins 43 bulge and make close contact with the inner faces of the second cavities 63 due to the resin being filled into the inner side of the fins 43.

Resin that has reached the apexes 43A of the fins 43 rebounds off the apexes 43A and flows to the end portions inner side the fins 43 at both length L direction sides thereof.

Some of the resin that has flowed to the end portions at both length direction sides of the fins 43 passes through the cut-outs 45 formed in the fins 43 and fills into the gaps 67 between the apexes 43A of the fins 43 and the bottom faces 63B of the second cavities 63 as indicated by the arrows B in Fig. 29. The rest of resin that has flowed to the end portions at both length direction sides of the fins 43 passes through the cut-outs 47 formed in the bottom portions 44A and fills into the gaps 68 between the leading end portions 64A of the projections 64 and the bottom portions 44A as indicated by the arrows C in Fig. 29.

Then, resin filled into the mold 51 as described above is cooled and solidified to form the base 13, the plural protrusions 14, the plural protection portions 15, and the plural covering portions 16, similarly to in the fourth exemplary embodiment.

In the fifth exemplary embodiment, an electronic device 130 (see Fig. 29) is manufactured under the above principles. In the electronic device 130 thus manufactured, the covering portions 16 cover the entirety of the bottom portions 44A of the grooves 44 formed between the plural fins 43. The main body 12 and the covering portions 16 are integrally formed through coupling portions 20 formed in the cut-outs 47.

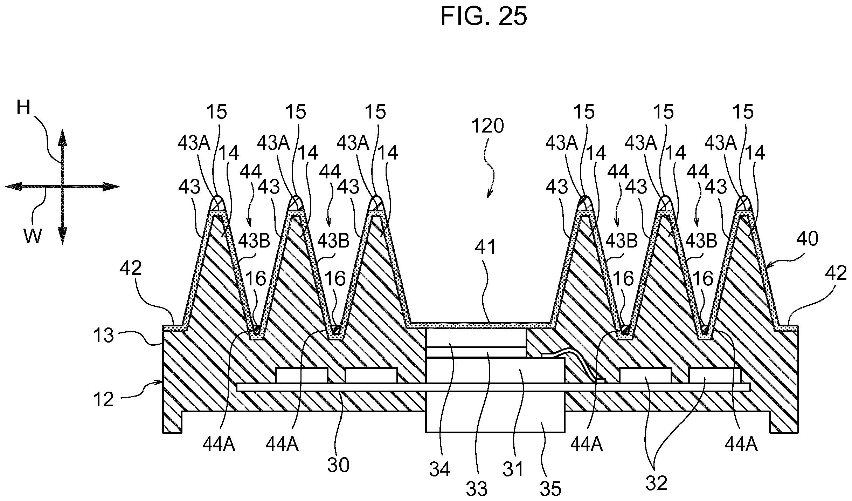

Moreover, the main body 12, the protection portions 15, and the covering portions 16 are made of resin, and are integrated with the heat dissipating sheet 40 by molding. The covering portions 16 are formed in long, thin plate shapes and, similarly to in the fourth exemplary embodiment, are provided to the bottom portion 44A sides of the grooves 44. Portions of the side face portions 43B of the fins 43 between the covering portions 16 and the protection portions 15 are exposed to the exterior due to the covering portions 16 being thinly formed (see Fig. 25).

The bottom portions 44A of the grooves 44 are likewise covered by the covering portions 16 in the electronic device 130 according to the fifth exemplary embodiment. Accordingly, for example, even when foreign matter that has collected in the grooves 44 is removed using a cleaning tool such as a brush, contact between the cleaning tool and the bottom portions 44A is prevented, enabling damage to the surface of the bottom portions 44A to be suppressed. This enables reduction of the heat dissipation performance of the heat dissipating sheet 40 to be suppressed even when the heat dissipating sheet 40 is formed from, for example, a soft, easily damaged material.

As illustrated in Fig. 29, in the heat dissipating sheet 40 according to the fifth exemplary embodiment, the length L direction end portions 40A are inclined with respect to the height H direction so as to slope out toward the length L direction end sides on progression toward the height H direction lower side. Accordingly, the surface area of the side face portions of the heat dissipating sheet 40 increases by an amount corresponding to this inclination, enabling the heat dissipation performance of the heat dissipating sheet 40 to be improved.

Although the cut-outs 47 of the heat dissipating sheet 40 are cut out in circular arc shapes in the fifth exemplary embodiment, a shape other than a circular arc may be cut out.

### Sixth Exemplary Embodiment that forms part of the invention

Next, explanation follows regarding a sixth exemplary embodiment according to technology disclosed herein.

In the sixth exemplary embodiment, the manufacturing method differs as follows from the manufacturing method for an electronic device according to the fifth exemplary embodiment, described above.

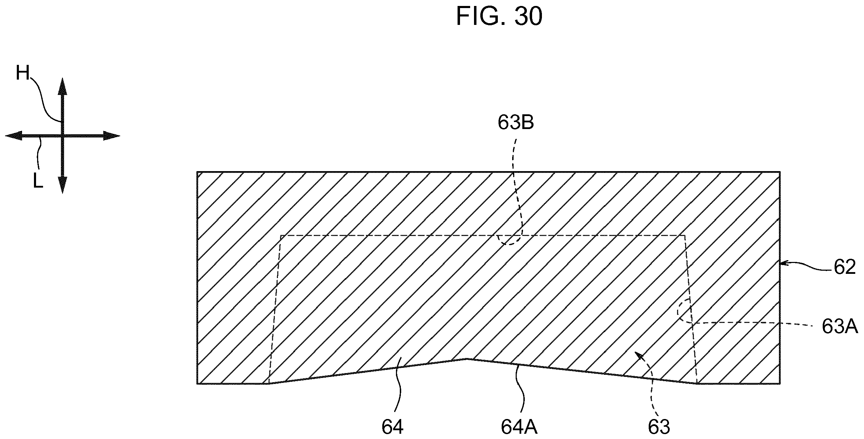

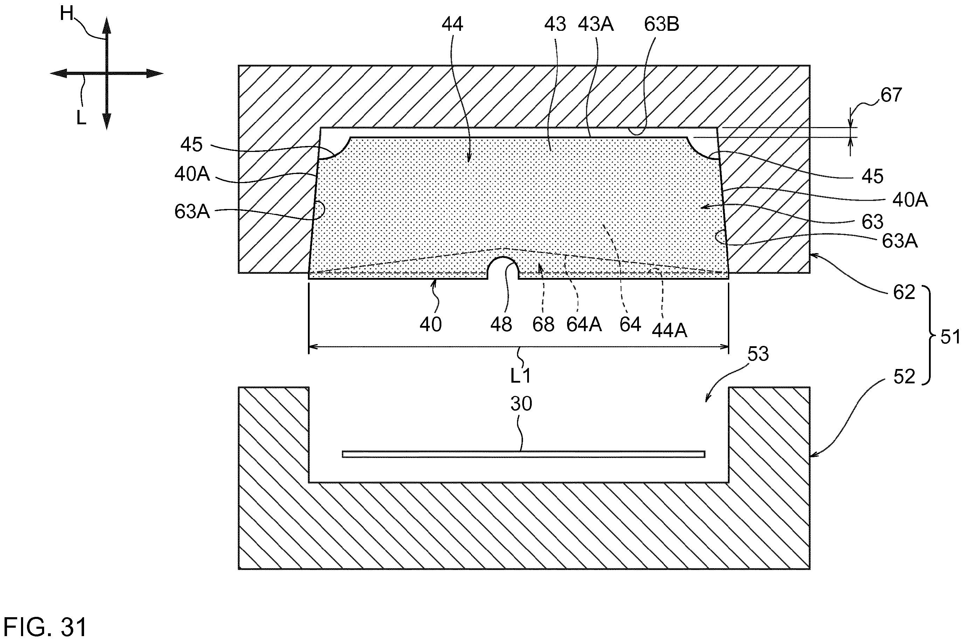

As illustrated in Fig. 30, in the manufacturing method for an electronic device according to the sixth exemplary embodiment, the second mold 62 is structured as follows. The projections 64 of the second mold 62 are formed such that the length L direction central portions thereof have a shorter projection length that that of the end portions at both length L direction sides thereof. Namely, as illustrated in Fig. 31, the leading end portions 64A of the projections 64 are formed so as to slope toward the bottom portions 44A on progression from the length L direction central portions thereof toward the end portions. In the sixth exemplary embodiment, an electronic device is manufactured under the following principles using a second mold 62 with such a structure.

First, as illustrated in Fig. 31, the substrate 30 is housed in the first cavity 53 inner side the first mold 52, and the heat dissipating sheet 40 is housed in the second cavities 63 inner side the second mold 62.

The heat dissipating sheet 40 is pre-formed so as to have a length in the length L direction that is equal to the length L1 of the first cavity 53 and the second cavities 63 in the length L direction. Namely, in the sixth exemplary embodiment, the length L direction end portions 40A of the heat dissipating sheet 40 are inclined with respect to the height H direction so as to slope out toward the length L direction end sides on progression toward the height H direction lower side. Then, in a state in which the heat dissipating sheet 40 is attached to the second mold 62, the length L direction end portions 40A of the heat dissipating sheet 40 extend in a straight line along the side faces 63A of the second cavities 63 in the length L direction. Moreover, the bottom portions 44A are formed in flat shapes, and are positioned at the same height as the lower face of the second mold 62.

Holes 48, which are examples of an "inflow port", are pre-formed in length direction central portions of the bottom portions 44A of the heat dissipating sheet 40. The holes 48 are formed when the heat dissipating sheet 40 is pressed. The holes 48 penetrate the thickness direction of the bottom portions 44A and place the inner side of the fins 43 in communication with the grooves 44. The holes 48 are each formed in a circular shape as an example. Moreover, the gaps 68 are formed between the leading end portions 64A of the projections 64 of the second mold 62 inserted into the grooves 44 and the bottom portions 44A. Then, in a state in which the heat dissipating sheet 40 and the substrate 30 are thus set up in the mold 51, the first mold 52 and the second mold 62 are assembled together.

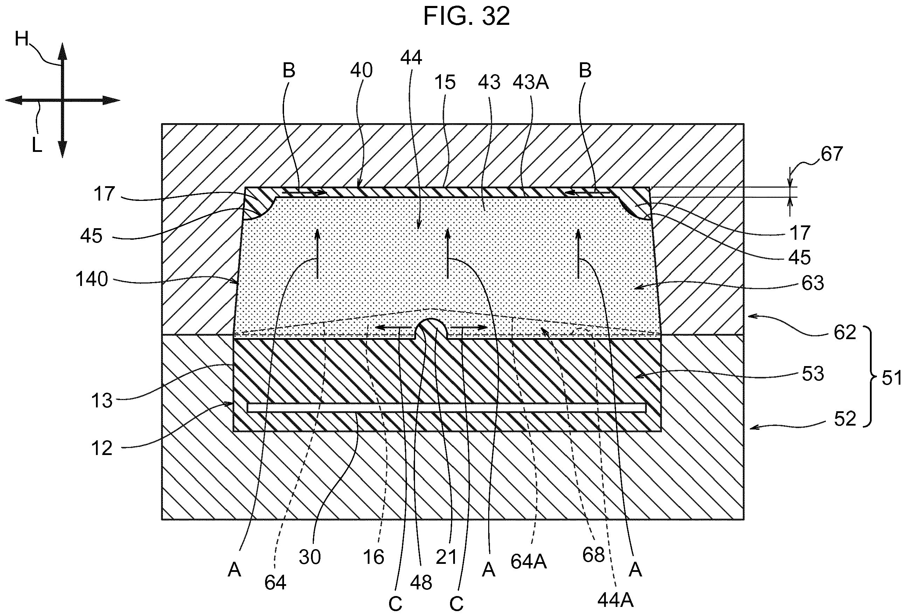

Next, as illustrated in Fig. 32, resin, which is an example of a "first material", is injected into the mold 51 in a molten state. The resin injected into the mold 51 flows from the inner side of the fins 43 toward the apexes 43A of the fins 43 as indicated by the arrows A in Fig. 32, and is filled into the inner side of the fins 43. The fins 43 bulge and make close contact with the inner faces of the second cavities 63 due to the resin being filled into the inner side of the fins 43.

Resin that has reached the apexes 43A of the fins 43 rebounds off the apexes 43A and flows to the end portions inner side the fins 43 at both length L direction sides thereof. Some of the resin that has flowed to the end portions inner side the fins 43 at both length L direction sides thereof passes through the cut-outs 45 formed in the apexes 43A and fills into the gaps 67 between apexes 43A of the fins 43 and the bottom faces 63B of the second cavities 63 as indicated by the arrows B in Fig. 32. The rest of the resin that has flowed to the end portions at both length L direction sides of the fins 43 passes through the holes 48 formed in the bottom portions 44A and fills into the gaps 68 between the leading end portions 64A of the projections 64 and the bottom portions 44A as indicated by the arrows C in Fig. 32.

Then, the resin filled into the mold 51 as described above is cooled and solidified to form the base 13, the plural protrusions 14, the plural protection portions 15, and the plural covering portions 16, similarly to in the fourth and fifth exemplary embodiments.

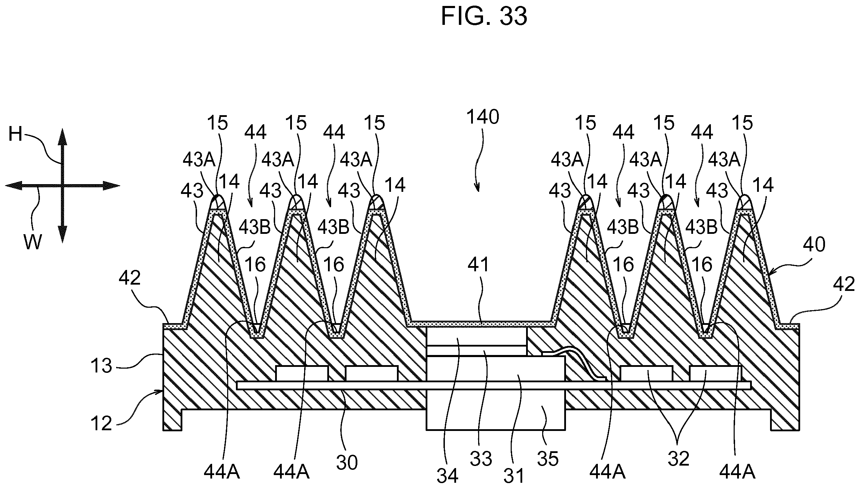

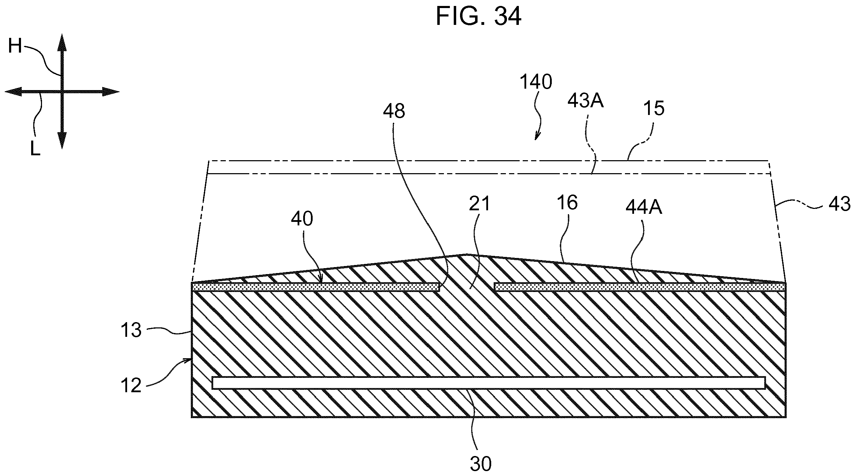

In the sixth exemplary embodiment, an electronic device 140 (see Fig. 33) is manufactured under the above principles. In the electronic device 140 thus manufactured, the covering portions 16 entirely cover the bottom portions 44A of the grooves 44 formed between the plural fins 43. The main body 12 and the covering portions 16 are integrally formed through coupling portions 21 (see Fig. 34) formed in the holes 48.

Moreover, the main body 12, the protection portions 15, and the covering portions 16 are made of resin, and are integrated with the heat dissipating sheet 40 by molding. The covering portions 16 are formed in long, thin plate shapes and are provided to the bottom portion 44A sides of the grooves 44. Portions of side face portions 43B of the fins 43 between the covering portions 16 and the protection portions 15 are exposed to the exterior due to the covering portions 16 being thinly formed. As illustrated in Fig. 34, the covering portions 16 are formed such that the thickness of the length L direction central portions of the covering portions 16 is thicker than the thickness of both length L direction end portions of the covering portions 16.

In the electronic device 140 according to the sixth exemplary embodiment, the covering portions 16 are formed such that the thickness of the length L direction central portions of the covering portions 16 is thicker than the thickness of both length L direction end portions of the covering portions 16. Accordingly, in cases in which, for example, the electronic device 140 is employed outdoors with the fins 43 facing upward, foreign matter that has collected on the covering portions 16 can be washed off by rainfall due to the incline (taper) of the covering portions 16.

### Seventh Exemplary Embodiment that forms part of the invention

Next, explanation follows regarding a seventh exemplary embodiment according to technology disclosed herein.

In the seventh exemplary embodiment, the manufacturing method differs from the manufacturing method for an electronic device according to the fourth to the sixth exemplary embodiments, described above, as follows.

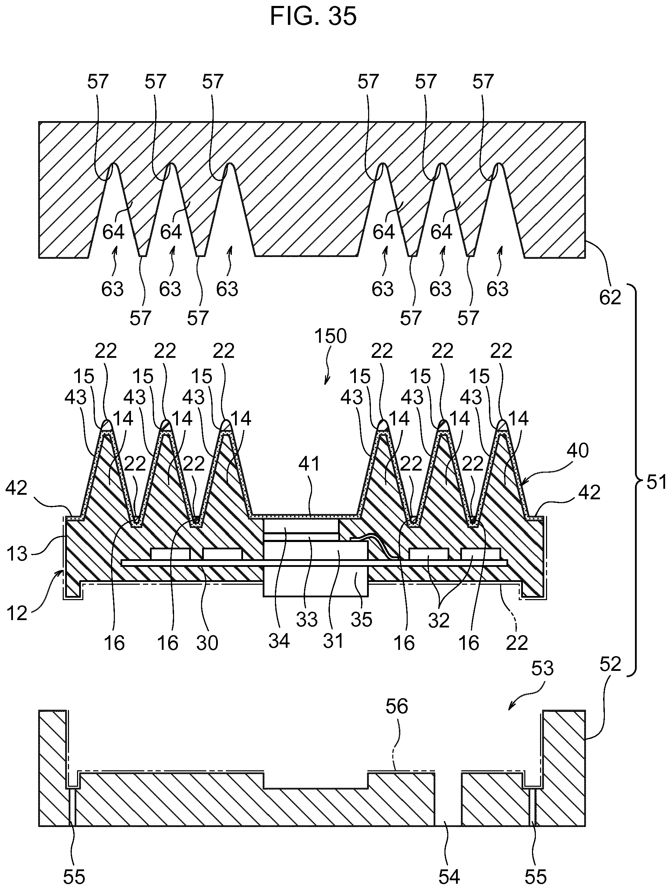

As illustrated in Fig. 35, in the manufacturing method for an electronic device according to the seventh exemplary embodiment, the mold 51 is structured as follows. Out of the inner faces (molding faces) of the first cavity 53 formed in the first mold 52, the side faces of the first cavity 53 that oppose the side faces of the main body 12 and the bottom faces of the first cavity 53 that oppose the bottom faces of the main body 12, are each formed with a transfer portion 56. Similarly, out of the inner faces (molding faces) of the second cavities 63 formed in the second mold 62, the bottom side faces of the second cavities 63 that oppose the surface of the protection portions 15 and the leading end faces of the projections 64 that oppose the surface of the covering portions 16, are each formed with a transfer portion 57.

The respective transfer portions 56, 57 are structured to include indentations and protrusions so as to be able to form graining 22 on the surfaces of the main body 12, the protection portions 15, and the covering portions 16 as described below. In the seventh exemplary embodiment, an electronic device 150 is manufactured under similar principles to those of the fourth to the sixth exemplary embodiment described above, using the mold 51 that includes such transfer portions 56, 57.

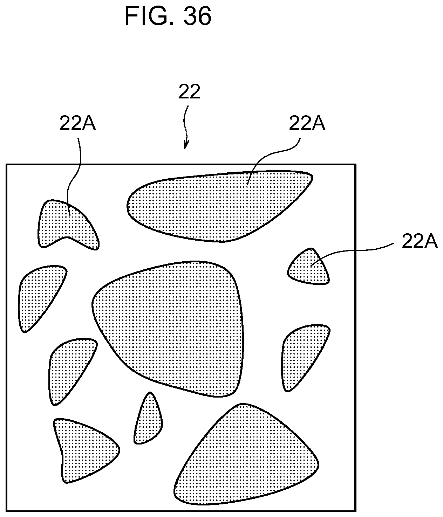

In the electronic device 150 thus manufactured, the graining 22 is respectively formed on the side faces of the main body 12, the bottom faces of the main body 12, the surface of the protection portions 15, and the surface of the covering portions 16 as an example of "anti-fouling treatment", using the transfer portions 56, 57. As illustrated in Fig. 36, the graining 22 includes plural protrusions 22A (land portions). A shape that exhibits the advantageous effects of not being easily damaged, not easily becoming dirty, and being easily cleaned is suitably applied for the graining 22.

In this manner, in the seventh exemplary embodiment, the side faces of the main body 12, the bottom faces of the main body 12, the surface of the protection portions 15, and the surface of the covering portions 16 are formed with the graining 22. Due to the graining 22, this thereby enables the side faces of the main body 12, the bottom faces of the main body 12, the surface of the protection portions 15, and the surface of the covering portions 16 to be suppressed from becoming dirty.

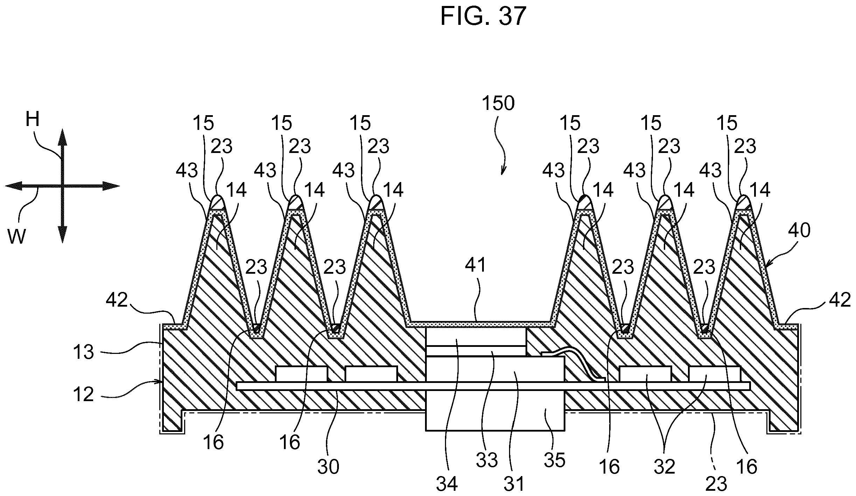

In the seventh exemplary embodiment, as illustrated in Fig. 37, as an example of "anti-fouling treatment", a fine periodic structure 23 may be formed on the side faces of the main body 12, the bottom faces of the main body 12, the surface of the protection portions 15, and the surface of the covering portions 16, instead of the graining 22 described above (see Fig. 35 and Fig. 36).

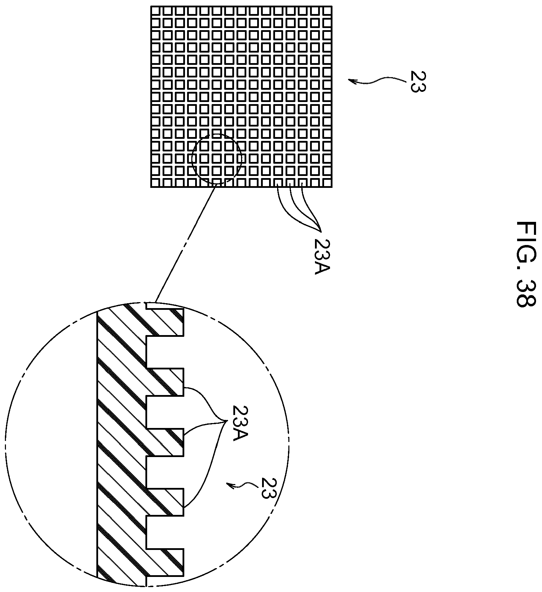

The fine periodic structure 23 is formed by changing the structure of the transfer portions 56, 57 of the mold 51. As illustrated in Fig. 38, as an example, the fine periodic structure 23 includes plural fine projections 23A that form a lattice. The array pitch of the plural fine projections 23A is preferably from 5 µm to 20 µm. For example, a shape that exhibits water repellency due to the lotus effect, or a shape that exhibits self-cleaning activity, is suitably applied as the fine periodic structure 23. The fine periodic structure 23 that has such plural fine projections 23A also enables the side faces of the main body 12, the bottom faces of the main body 12, the surface of the protection portions 15, and the surface of the covering portions 16 to be suppressed from becoming dirty.

Moreover, although the graining 22 or the fine periodic structure 23 is formed by the transfer portions 56, 57 in the seventh exemplary embodiment, the graining 22 or the fine periodic structure 23 may be formed by an additional process after removing the electronic device 150 from the mold 51.

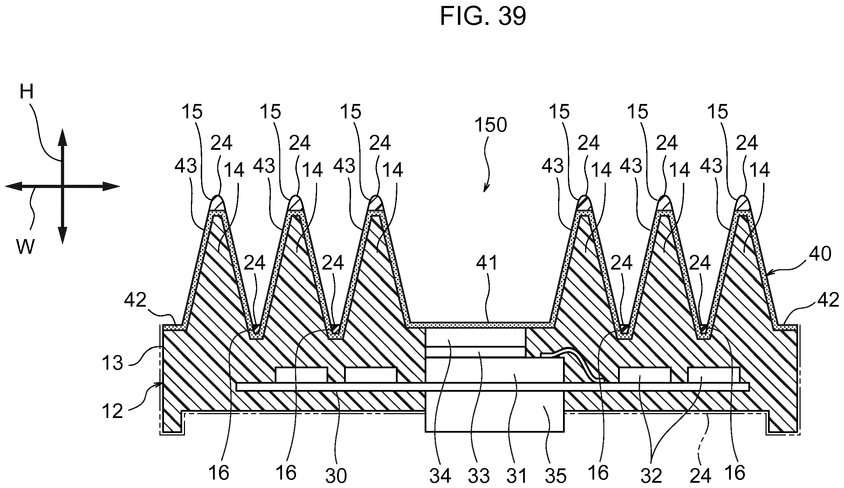

Moreover, as illustrated in Fig. 39, after removing the electronic device 150 from the mold 51, a coating layer 24 having hydrophilicity and hydrophobicity may be formed as an example of "anti-fouling treatment". The coating layer 24 is formed on the side faces of the main body 12, the bottom faces of the main body 12, the surface of the protection portions 15, and the surface of the covering portions 16.

For the coating layer 24, it is possible to employ a coating material having hydrophilicity and hydrophobicity. Examples of such coating materials include a combination of an acrylic polymer having hydrophilicity and a fluorine polymer having hydrophobicity, or fine particles of a hydrophobic fluorine resin dispersed in a hydrophilic coating material at intervals smaller than dirt particles. Such a coating layer 24 also enables the side faces of the main body 12, the bottom faces of the main body 12, the surface of the protection portions 15, and the surface of the covering portions 16 to be suppressed from becoming dirty.

In the seventh exemplary embodiment, the graining 22, the fine periodic structure 23, and the coating layer 24 may be formed anywhere, as long as they are formed on at least part of the surfaces of the resin portions including the main body 12, the protection portions 15, and the covering portions 16.

### Eighth Exemplary Embodiment

Next, explanation follows regarding an eighth exemplary embodiment according to technology disclosed herein.

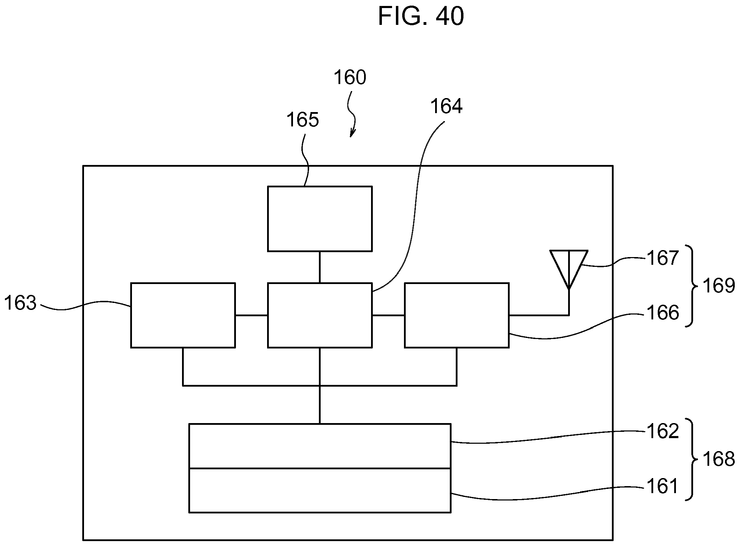

As illustrated in Fig. 40, an integrated module 160 according to the eighth exemplary embodiment includes a power generating module 161, a power storing module 162, a sensor 163, a controller 164, a memory 165, a communication circuit 166, and an antenna 167.

For example, the electronic device of the first to the seventh exemplary embodiments described above is employed in the power generating module 161. Namely, the power generating module 161 includes the substrate 30 packaged with the thermoelectric element 31 and the like (not including the communication component 32), the main body 12, the heat dissipating sheet 40, the plural protection portions 15, and the plural covering portions 16 (see Fig. 1 to Fig. 39, described above).

The power storing module 162 is connected to the power generating module 161, and stores power generated by the power generating module 161. Any component with functionality for storing power may be employed as the power storing module 162. The power storing module 162 is preferably, for example, a solid-state secondary battery, from the viewpoints of having high safety while saving space.

The power generating module 161 and the power storing module 162 form a power supply section 168. Power is supplied to the sensor 163, the controller 164, and the communication circuit 166 from at least one out the power generating module 161 and the power storing module 162 that form the power supply section 168. The power storing module 162 may be omitted in cases in which power can be supplied stably from the power generating module 161.

The sensor 163 is an example of a "detector". For example, a sensor that detects temperature, humidity, pressure, light, sound, electromagnetic waves, acceleration, vibration, gas, fine particles, or the like may be employed as the sensor 163. Moreover, a distance sensor that measures a distance to a target object by emitting infrared light toward the target object and receiving light reflected back from the target object, a weight sensor that measures the weight of a target object, a water level sensor that detects data such a water level, or the like may be employed as the sensor 163.

The controller 164, for example, transmits various data detected by the sensor 163 to a server 175 via the communication circuit 166 and the antenna 167. The controller 164 may, for example, transmit secondary data based on the various data detected by the sensor 163 and other data to the server 175. Moreover, the controller 164 may, for example, compute secondary data by performing a specific calculation using the various data detected by the sensor 163, and transmit the secondary data to the server 175.

The memory 165 stores the various data detected by the sensor 163 and computed secondary data on instruction by the controller 164. Stored information is read on instruction from the controller 164.

The communication circuit 166 and the antenna 167 form a communication section 169. The communication section 169 transmits and receives data between the controller 164 and the server 175. Although wireless communication using the antenna 167 is employed as illustrated in the example of Fig. 40, wired communication may be employed instead of wireless communication.

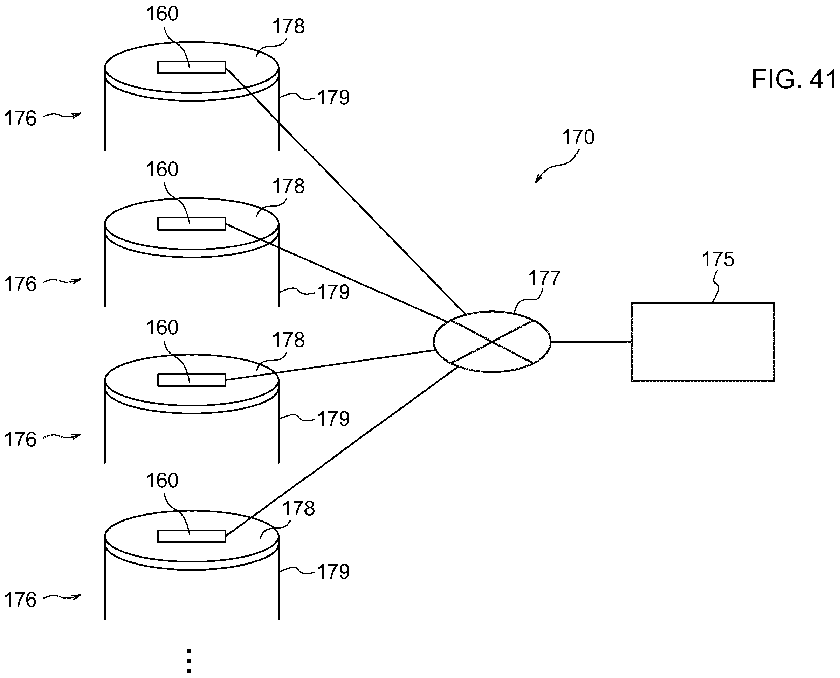

As illustrated in Fig. 41, the integrated module 160 described above is employed, for example, in an information processing system 170 according to the eighth exemplary embodiment. The information processing system 170 includes plural integrated modules 160 and the server 175.

The plural integrated modules 160 are installed in manholes 176. The plural integrated modules 160 installed in the plural manholes 176 are connected to the server 175 via a network 177.

Note that, for example, data may be transmitted from the integrated modules 160 to the server 175 by near field communication each time a travelling vehicle provided with the server 175 approaches the integrated modules 160 installed in each of the manholes 176. An integrated module 160 may be installed anywhere on a structural member of a manhole 176.

Each integrated module 160 is, for example, fixed to a lid 178 or a concrete pipe 179, which are structural members of the manholes 176, depending on the detection target of the sensor 163 and the type of the sensor 163. The thermoelectric element 31 provided to each integrated module 160 is thermally connected to a structural member of the manhole 176, which is an example of an "installation target", and power is generated due to a temperature difference between the structural member of the manhole 176 and either external air or the temperature inner side the manhole 176.

Next, explanation follows regarding a specific application example of the information processing system 170 according to the eighth exemplary embodiment.

### First Example Application of Eighth Exemplary Embodiment

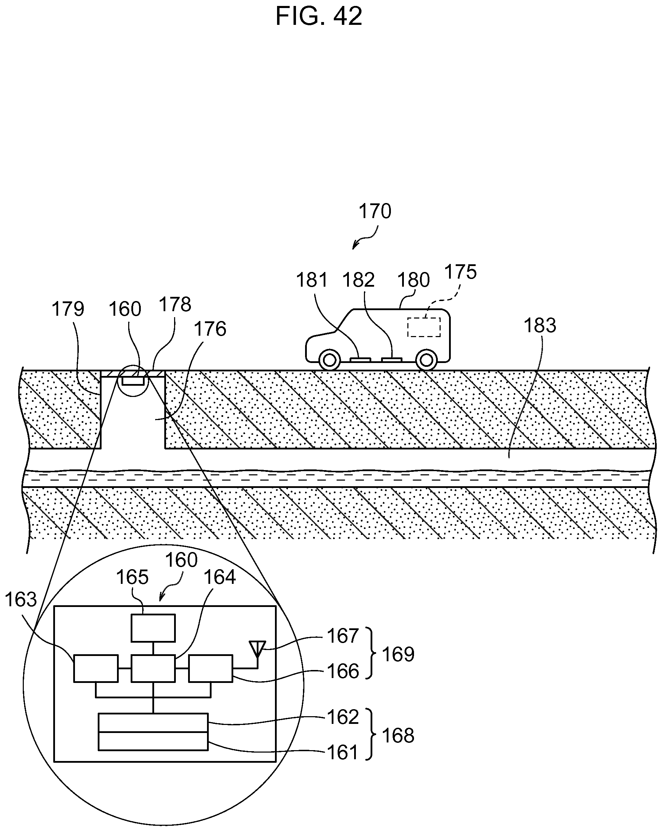

In a first example application illustrated in Fig. 42, the information processing system 170 is employed in order to ascertain degradation of the structural members of the manholes 176 (the lids 178 or the concrete pipes 179). The sensor 163 detects the temperature or humidity inner side each manhole 176, vibrations (acceleration) acting on the structural member of the manhole 176, or the like, and data detected by the sensor 163 is accumulated in the memory 165.

When a measuring vehicle 180 travelling on a road passes over the manhole 176, the controller 164 transmits the data accumulated by the memory 165 via the communication circuit 166 and the antenna 167. The server 175 provided to the measuring vehicle 180 collects the data.

The server 175 combines position information of the vehicle 180 from a global positioning system (GPS) with the collected data, and displays the collected data on a map displayed on an in-car monitor. The degree of degradation of the concrete pipe 179 in each of the manholes 176 is estimated from the information expressing the temperature, humidity, vibrations, or the like.

In addition to a receiving device 181, a camera 182 that acquires images of the lid 178 of the manhole 176 is attached to a lower portion of the measuring vehicle 180, and degradation of the lid 178 (an iron part) of the manhole 176 is determined using image recognition. Based on the result, the time to replace the lid 178 of the manhole 176 may be sold as information to a local government. Rather than a specialized measuring vehicle, the vehicle collecting the data may, for example, be a garbage truck operated by the local government. Installing the receiving device 181 and the camera 182 to the bottom portion of a garbage truck enables data to be collected periodically without incurring collection expenses.

The sensor 163 may detect the concentration of a gas generated inner side the manhole 176. Hydrogen sulfide gas is an example of gas generated inner side the manhole 176. Hydrogen sulfide gas generated by a sewer 183 is known to rapidly degrade structural members of manholes 176. The generation of hydrogen sulfide gas is also a cause of complaint among local residents. Using a hydrogen sulfide gas sensor as the sensor 163 increases the precision of degradation predictions for the structural members of manholes 176, and enables complaints by residents to be swiftly dealt with.

In the first example application, it is sufficient for the sensor 163 to detect at least one out of the temperature, humidity, or vibrations inner side the manhole 176, or a concentration of gas generated inner side the manhole 176.

There is also a possibility that the humidity inner side the manhole 176 is always high, or that water in the sewer 183 (or water supply) overflows inner side the manhole 176. Although the temperature is approximately constant inner side the manhole 176, it is known, for example, that the lid 178 is at higher temperature in summer and at lower temperature in winter, and that hydrogen sulfide gas and so on is generated, causing various metals to dissolve. It is important to protect electronic components such as the sensor 163 and the thermoelectric element 31 in such harsh environments, and to maintain long-term reliability. According to the integrated module 160, long-term reliability can be maintained since the electronic components such as the sensor 163 and the thermoelectric element 31 are encapsulated by resin.

### Second Example Application of Eighth Exemplary Embodiment

Next, explanation follows regarding a second example application of the eighth exemplary embodiment.

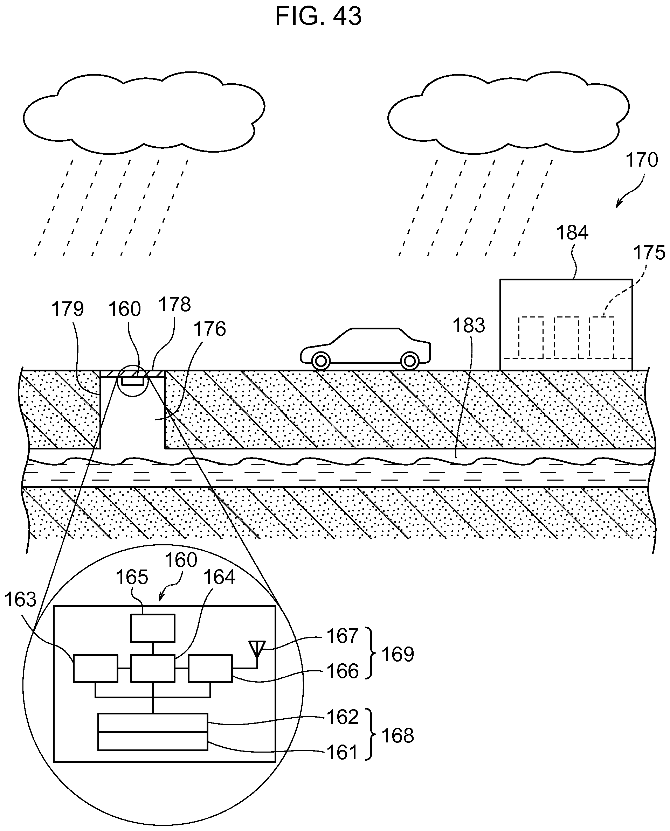

In the second example application illustrated in Fig. 43, the information processing system 170 is applied in order to predict a flow rate in the sewer 183 connected to the manholes 176. A water level meter or a flow meter, for example, is employed as the sensor 163. Installing the sensor 163, which is a water level meter or a flow meter, in the manholes 176 enables the flow rate in the sewer 183 to be ascertained in fine detail. Although the sensor 163 is incorporated into the integrated module 160 in Fig. 43, for example, a sensor controller that controls the operation of an external sensor may be provided instead of the sensor 163. The sensor controller may control a sensor such as a water level meter or a flow meter, not illustrated in the drawings, disposed in the sewer 183, and may acquire information detected by the sensor. Moreover, information detected by the sensor may be transmitted to the sensor controller wirelessly.

More specifically, the flow rate in the sewer 183 is detected by the sensor 163 once every day, or once every hour, and data detected by the sensor 163 travels along a high speed communication line and is gathered in the server 175 of a data center 184. The flow rate data of the sewer 183 detected by the sensor 163 may be transmitted at the same time that measurement is made, or may be accumulated and then transmitted every day or week in order to reduce power consumption. Alternatively, data may be collected by a measuring vehicle similarly to in the first application example.

Normally, rainwater flows into the sewer 183, such that predictions of flow rate in the sewer 183 are strongly related to rainfall data. Accordingly, analyzing a combination of flow rate data in the sewer 183 gathered by sensor 163 and rainfall data from a meteorological agency enables, for example, flood predictions, and warnings and alerts to be provided for waterways that the sewer 183 flows into.

A relationship can be established between weather phenomena and the flow rate in the sewer 183 from the results of analysis of flow rate data in the sewer 183 and rainfall data from a meteorological agency. Then, the flow rate in the sewer 183 at each location may be predicted from the rainfall data of the meteorological agency, and charges made for the provision and distribution of the prediction data. An information processing system 170 capable of continuously updating data is useful since flow rates in the sewer 183 may change from year to year according to residential home construction or residential statuses, and land development status.

In the second example application, the information processing system 170 can also be utilized for flow rate measurements in the sewer 183 in cases of locally concentrated heavy rainfall or the like. During locally concentrated heavy rainfall in a city, minute-by-minute measurement and information transmission of water levels in the sewer 183 are needed to secure worker safety in the sewer 183 and to prevent the sewer 183 from flooding. In such cases, data gathering may be limited to a small number of integrated modules 160 installed in manholes 176 at relatively low elevations.

The power storing module 162 of the integrated module 160 that measures the water level is preferably stored with sufficient power in advance. The controller 164 sequentially transmits data to the server 175 through the communication circuit 166 and a high speed communication line. The server 175 can issue the received data as a warning to the smartphones and tablets of workers and residents near the flooding. Alternatively, data may be collected in a server provided to a measuring vehicle parked over a specific manhole 176, using near field communication.

### Third Example Application of Eighth Exemplary Embodiment

Next, explanation follows regarding a third example application of the eighth exemplary embodiment.

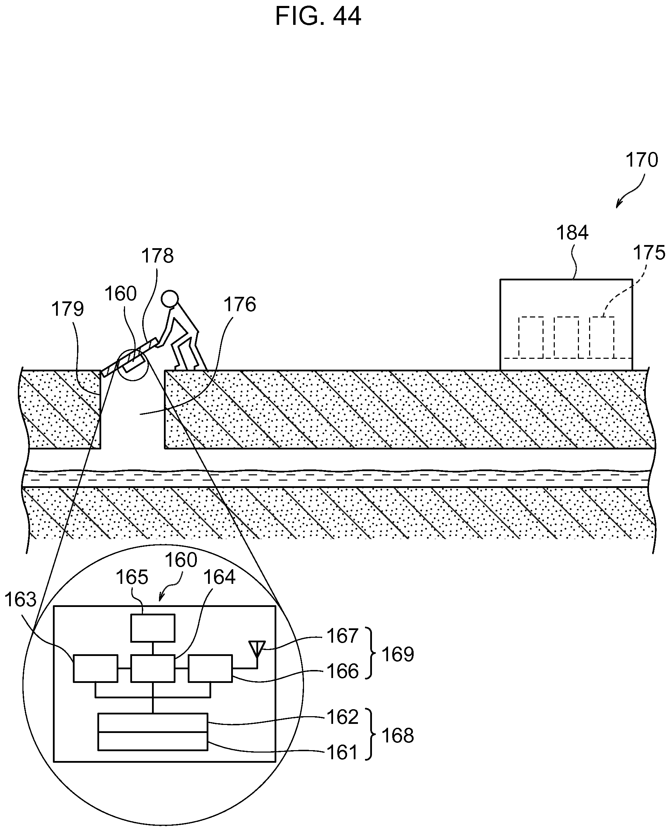

In the third example application illustrated in Fig. 44, the information processing system 170 is employed for the security and operation history of the manholes 176. The sensor 163 detects opening and closing of the lids 178 of the manholes 176. An acceleration sensor or an opening and closing switch, for example, is employed as the sensor 163. It is sufficient for the sensor 163 to detect at least one out of acceleration of the lid 178 of the manhole 176 or open and closed states of the lid 178 of the manhole 176 in order to detect opening and closing of the lid 178 of the manhole 176. Data (signals) output from the sensor 163 in accordance with the opening and closing of the lid 178 of the manhole 176 is received by the server 175.

According to the information processing system 170, security countermeasures (for example, terrorist bombing countermeasures) for the sewer 183 etc., and the operation history of cleaning operations of the sewer 183, can be confirmed.

### Fourth Example Application of Eighth Exemplary Embodiment

Next, explanation follows regarding a fourth example application of the eighth exemplary embodiment.

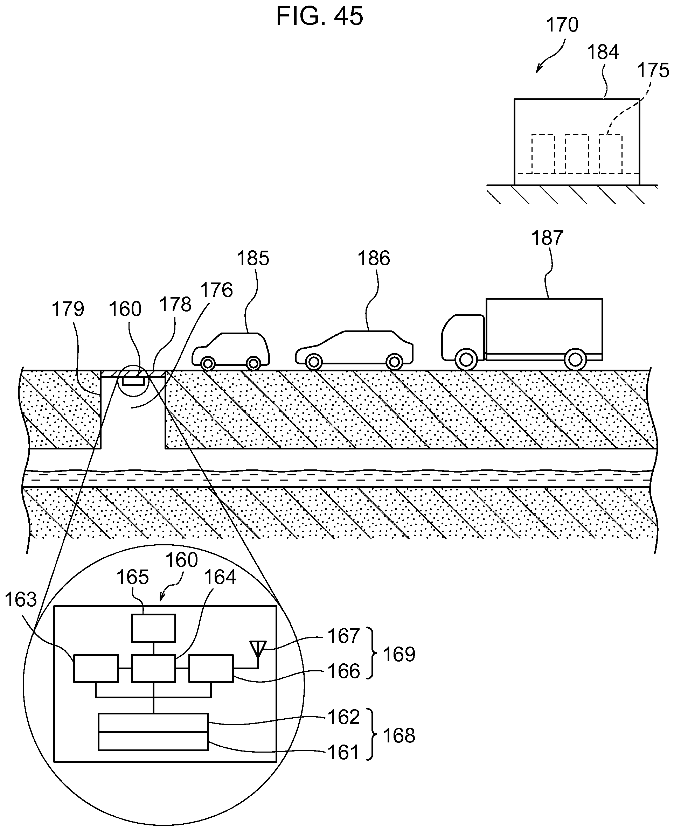

In the fourth example application illustrated in Fig. 45, the information processing system 170 is employed for acquiring road traffic information. The sensor 163 detects vehicles 185, 186, 187 passing over the manhole 176. For example, an acceleration sensor, a magnetic sensor, a microphone, or the like may be employed as the sensor 163. Signals corresponding to the number of vehicles that pass over the manhole 176 are obtained from the sensor 163. Data (signals) output from the sensor 163 are received by the server 175.

According to the information processing system 170, traffic information can be obtained even for small roads, alleyways, and the like for which measurements are not made using current road traffic information communication systems. This enables finely detailed traffic information to be provided.

Moreover, the type of the vehicle 185, 186, 187 (for example, small car, regular car, or truck) passing over the manhole 176 may be detected from the magnitude of the detection value of the sensor 163. In such cases, a data set associating the detection value of the sensor 163 with the type of the vehicle may be pre-stored in the memory 165. Information indicating the type of vehicle determined from the detection value of the sensor 163 and the data set described above is transmitted from the controller 164 to the server 175. This enables the type of vehicle passing over the manhole 176 to be ascertained.

Moreover, individual identification information of the vehicle 185, 186, 187 passing over the manhole 176 may be detected by the sensor 163. For example, in cases in which a magnetic sensor is employed as the sensor 163, it is possible that the characteristics of the vehicle could be obtained from the response of the magnetic sensor. Namely, individual vehicles can be recognized by, for example, installing a medium that gives out characteristic magnetism by vehicle. Analysis of differences in the flow of vehicles in a city by vehicle type is relevant to municipal road control and municipal evaluation, such as for schemes to guide certain vehicles onto certain roads.

In the fourth example application, it is sufficient for the sensor 163 to detect at least one out of the number, type, or individual identification information of vehicles passing over the manhole 176.

### Fifth Example Application of Eighth Exemplary Embodiment

Next, explanation follows regarding a fifth application example of the eighth exemplary embodiment.

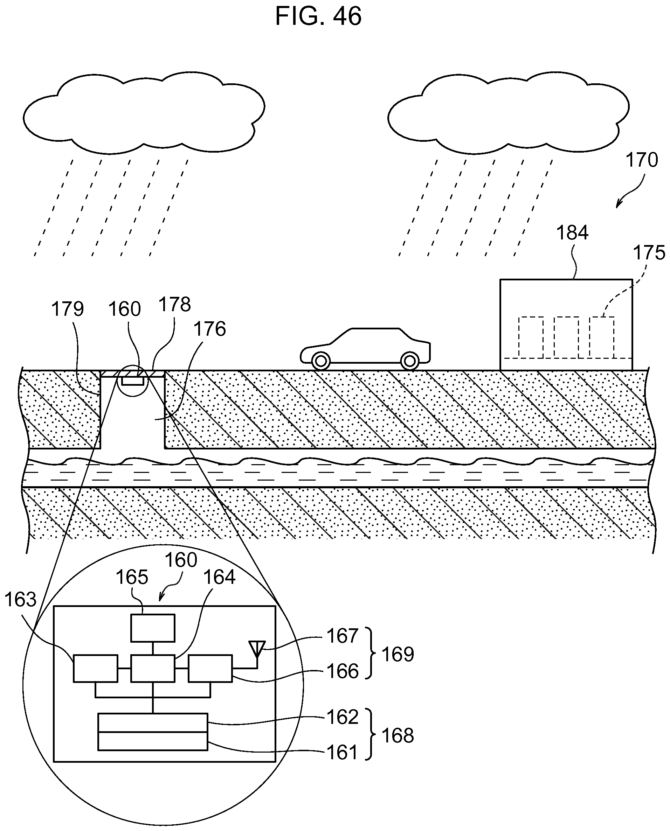

In the fifth example application illustrated in Fig. 46, the information processing system 170 is employed for measuring amounts of rainfall. For example, X-band radar for predicting weather is employed as the sensor 163. Radio waves from X-band radar, for example, do not reach beyond an area where heavy rain is falling during heavy rains, and will not cross over large objects such as mountains. Moreover, there are many issues in current radars regarding spotting and tracking of areas where heavy rain suddenly or rapidly begins to fall. Highly precise prediction demands high temporal and spatial resolution.

Although the resolution of X-band radar is normally 250 m, installing the sensors 163 in manholes 176 at average intervals of approximately 30 m could conceivably enable more finely detailed weather prediction and assist measurements and predictions for locally concentrated heavy rainfall or the like. Data (signals) output from the sensors 163 is received by the server 175.

Although a dedicated server 175 is employed in the first to the fifth example applications described above, a regular computer may be employed as the server 175. A program that executes operations performed by the controller 164 and the server 175 may be installed and executed in a regular computer that functions as the server 175. In such cases, the program may be supplied using a recording medium or may be downloaded over a network.

Although explanation has been given regarding the first to the eighth exemplary embodiments of technology disclosed herein, technology disclosed herein is not limited to the above description, and obviously, in addition to the above description, various modifications may be implemented within a range not departing from the spirit of technology disclosed herein.

The first to the eighth exemplary embodiments, modified examples thereof, and example applications thereof may be implemented in combination as appropriate.

In embodiments, particularly in manufacturing methods, it may be that a set state is adopted in which the heat dissipating sheet (40) bent so as to form the fin (43) is housed inner side the mold (51), and an inflow port is formed at the bottom portion (44A); and, in the set state, the first material is injected into the mold (51) toward the inner side of the fin (43), the first material at the inner side of the fin (43) passes through the inflow port and fills a gap (68) between a leading end portion (64A) of a projection (64) of the mold (51) inserted into the groove (44) and the bottom portion (44A), so as to form the covering portion (16) from the first material.

In embodiments, particularly in electronic devices, it may be that the electronic component (31) is a thermoelectric element (31) thermally connected to an installation target (72/178, 179) that is provided at an opposite side of the electronic component (31) from the heat dissipating sheet (40), such that the electronic component (31) is sandwiched therebetween.

Embodiments include a manufacturing method for an electronic device (10), the manufacturing method comprising: housing an electronic component (31) in a mold (51), together with housing in the mold (51) a heat dissipating sheet (40) that is formed from a second material having higher thermal conductivity than a first material forming a main body (12) of a heat dissipating component (50), and that includes a fin (43) and a connecting portion (41) thermally connecting the fin (43) and the electronic component (31) together; and filling the first material into the mold (51) to form the main body (12), and integrating the main body (12) and the heat dissipating sheet (40) covering the main body (12) together.

Embodiments include an integrated module (80/160) comprising: a power supply section (31/168) including a thermoelectric element (31) thermally connected to an installation target (72/178, 179); a main body (12) that is formed from a first material and that encapsulates the thermoelectric element (31); a heat dissipating sheet (40) that is formed from a second material having higher thermal conductivity than the first material, that covers the main body (12), and that includes a fin (43) and a connecting portion (41) thermally connecting the fin (43) and the thermoelectric element (31) together; a detector (83/163) that operates using power from the power supply section (31/168); and a communication section (32/169) that operates using power from the power supply section (31/168) and that transmits data detected by the detector (83/163).

Embodiments include an information processing system (70/170) comprising: an integrated module (80/160); and a server (85/175) that receives data transmitted from the integrated module (80/160), the integrated module (80/160) including: a power supply section (31/168) including a thermoelectric element (31) thermally connected to an installation target (72/178, 179); a main body (12) that is formed from a first material and that encapsulates the thermoelectric element (31); a heat dissipating sheet (40) that is formed from a second material having higher thermal conductivity than the first material, that covers the main body (12), and that includes a fin (43) and a connecting portion (41) thermally connecting the fin (43) and the thermoelectric element (31) together; a detector (83/163) that operates using power from the power supply section (31/168); and a communication section (32/169) that operates using power from the power supply section (31/168) and that transmits data detected by the detector (83/163).

## Claims

1. A heat dissipating component (50) comprising:
a main body (12) formed from a first material; and
a heat dissipating sheet (40) that is formed from a second material having higher thermal conductivity than the first material, that covers the main body (12), and that includes a fin (43), and a connecting portion (41) that is thermally connected to the fin (43) at a position other than an apex (43A) of the fin (43) and is also thermally connected to an electronic component (31);
the heat dissipating component (50), further comprising a protection portion (15) that is formed from the first material and that covers at least a portion of the apex (43A) of the fin (43);
wherein the heat dissipating sheet (40) further includes another fin (43) that that is thermally connected to the fin (43) at respective positions other than the apexes (43A) of the fins (43).

2. The heat dissipating component (50) of claim 1, wherein:
the protection portion (15) is provided at the apex (43A) side of the fin (43); and
a portion further to a base end side of the fin (43) than the protection portion (15) is exposed at a side face portion (43B) of the fin (43).

3. The heat dissipating component (50) of claim 1 or claim 2, wherein:
the fin (43) and the other fin (43) extend with a length direction along a direction intersecting an arrayed direction of the fin (43) and the other fin (43);
a communication port (45/46) is formed in the apex (43A) of the fin (43); and
the main body (12) and the protection portion (15) are integrally formed through a coupling portion formed at the communication portion (45/46).

4. The heat dissipating component (50) of any one of claim 1 to claim 3, further comprising a covering portion (16) that is formed from the first material and that covers at least a portion of a bottom portion (44A) of a groove (44) formed between the fin (43) and the other fin (43).

5. The heat dissipating component (50) of claim 4, wherein:
the covering portion (16) is provided at the bottom portion (44A) side of the groove (44); and
a portion between the covering portion (16) and the protection portion (15) is exposed at a side face portion (43B) of the fin (43).

6. The heat dissipating component (50) of claim 4 or claim 5, wherein:
the fin (43) extends with a length direction along a direction intersecting an arrayed direction of the fin (43) and the other fin (43);
the groove (44) between the fin (43) and the other fin (43) includes an opening; and
a length (L2) of the heat dissipating sheet (40) in the length direction is shorter than a length (L1) of the main body (12) in the length direction.

7. The heat dissipating component (50) of claim 6, wherein:
the bottom portion (44A) is at a lower position in a depth direction of the groove (44) than the connecting portion (41).

8. The heat dissipating component (50) of any one of claim 1 to claim 7, wherein at least a portion of a surface of a resin portion (12, 15, 16) including the main body (12) and formed from the first material is subjected to anti-fouling treatment (22/23/24).

9. A manufacturing method for a heat dissipating component (50), the manufacturing method comprising:
housing, in a mold (51), a heat dissipating (40) sheet that is formed from a second material having higher thermal conductivity than a first material forming a main body (12) of the heat dissipating component (50), and that includes a fin (43) and a connecting portion (41) that is thermally connected to the fin (43) at a position other than an apex (43A) of the fin (43) and is thermally connected to an electronic component (31); and
filling the first material into the mold (51) to form the main body (12), and integrating the main body (12) and the heat dissipating sheet (40) covering the main body (12), wherein the first material is filled into the mold (51), and a protection portion (15) that covers at least a portion of an apex (43A) of the fin (43) is formed of the first material.

10. The manufacturing method for a heat dissipating component (50) of claim 9, wherein:
a set state is adopted in which the heat dissipating sheet (40) bent so as to form the fin (43) is housed inner side the mold (51), a gap (68) is provided between the apex (43A) of the fin (43) and a bottom face (63B) of a cavity (63) formed inner side the mold (51), and a communication port (45/46) is formed at the apex (43A) of the fin (43); and,
in the set state, the first material is injected into the mold (51) toward the inner side of the fin (43), the first material at the inner side of the fin (43) passes through the communication port (45/46) and fills into the gap (68) between the apex (43A) of the fin (43) and the bottom face (63B) of the cavity (63), so as to form the protection portion (15) from the first material.

11. The manufacturing method for a heat dissipating component (50) of claim 9 or claim 10, wherein:
the first material is filled into the mold (51), and a covering portion (16) formed of the first material covers at least a portion of a bottom portion (44A) of a groove (44) formed between the fin (43) and another fin (43) that is thermally connected to the fin (43) at respective positions other than the apex portions (43A) of the fins (43).

## Patentansprüche

1. Wärmeableitende Komponente (50), umfassend:
einen Hauptkörper (12), der aus einem ersten Material gebildet ist; und
ein wärmeableitendes Blech (40), das aus einem zweiten Material mit einer höheren Wärmeleitfähigkeit als das erste Material gebildet ist, das den Hauptkörper (12) bedeckt und eine Rippe (43) und einen Verbindungsabschnitt (41) beinhaltet, der an einer anderen Position als einem Scheitelpunkt (43A) der Rippe (43) thermisch mit der Rippe (43) verbunden ist und auch thermisch mit einer elektronischen Komponente (31) verbunden ist;
die wärmeableitende Komponente (50), ferner umfassend einen Schutzabschnitt (15), der aus dem ersten Material gebildet ist und mindestens einen Abschnitt des Scheitelpunktes (43A) der Rippe (43) abdeckt;
wobei das wärmeableitende Blech (40) ferner eine weitere Rippe (43) beinhaltet, die thermisch mit der Rippe (43) an entsprechenden Positionen, außer an den Scheitelpunkten (43A) der Rippen (43), verbunden ist.

2. Wärmeableitende Komponente (50) nach Anspruch 1, wobei:
der Schutzabschnitt (15) an dem Scheitelpunkt (43A) der Rippe (43) vorgesehen ist; und
ein Abschnitt, der weiter zu einer Basisendseite der Rippe (43) verläuft, als der Schutzabschnitt (15) an einem Seitenflächenabschnitt (43B) der Rippe (43) freigelegt ist.

3. Wärmeableitende Komponente (50) nach Anspruch 1 oder Anspruch 2, wobei:
die Rippe (43) und die andere Rippe (43) sich mit einer Längsrichtung entlang einer Richtung erstrecken, die eine geordnete Richtung der Rippe (43) und der anderen Rippe (43) schneidet;
ein Verbindungsanschluss (45/46) in dem Scheitelpunkt (43A) der Rippe (43) ausgebildet ist; und
der Hauptkörper (12) und der Schutzabschnitt (15) integral durch einen am Verbindungsabschnitt (45/46) ausgebildeten Kupplungsabschnitt gebildet sind.

4. Wärmeableitende Komponente (50) nach einem beliebigen der Ansprüche 1 bis 3, ferner umfassend einen Abdeckabschnitt (16), der aus dem ersten Material gebildet ist und mindestens einen Abschnitt eines Bodenabschnitts (44A) einer Nut (44) abdeckt, die zwischen der Rippe (43) und der anderen Rippe (43) gebildet ist.

5. Wärmeableitende Komponente (50) nach Anspruch 4, wobei:
der Abdeckabschnitt (16) an dem Bodenabschnitt (44A) der Nut (44) vorgesehen ist; und
ein Abschnitt zwischen dem Abdeckabschnitt (16) und dem Schutzabschnitt (15) an einem Seitenflächenabschnitt (43B) der Rippe (43) freigelegt ist.

6. Wärmeableitende Komponente (50) nach Anspruch 4 oder Anspruch 5, wobei
die Rippe (43) sich mit einer Längsrichtung entlang einer Richtung erstreckt, die eine geordnete Richtung der Rippe (43) und der anderen Rippe (43) schneidet;
die Nut (44) zwischen der Rippe (43) und der anderen Rippe (43) eine Öffnung beinhaltet; und
eine Länge (L2) des wärmeabführenden Blechs (40) in Längsrichtung kürzer ist als eine Länge (L1) des Hauptkörpers (12) in Längsrichtung.

7. Wärmeableitende Komponente (50) nach Anspruch 6, wobei: der Bodenabschnitt (44A) sich in einer Tiefenrichtung der Nut (44) an einer niedrigeren Position befindet als der Verbindungsabschnitt (41).

8. Wärmeableitende Komponente (50) nach einem beliebigen der Ansprüche 1 bis 7, wobei mindestens ein Abschnitt einer Oberfläche eines Harzabschnitts (12, 15, 16), der den Hauptkörper (12) beinhaltet und aus dem ersten Material gebildet ist, einer Antifouling-Behandlung (22/23/24) unterzogen wird.

9. Herstellungsverfahren für eine wärmeabgebende Komponente (50), das Herstellungsverfahren umfassend:
Unterbringen eines wärmeabführendes (40) Blechs in einer Form (51), das aus einem zweiten Material mit einer höheren Wärmeleitfähigkeit als ein erstes Material gebildet ist, das einen Hauptkörper (12) der wärmeabführenden Komponente (50) bildet, und das eine Rippe (43) und einen Verbindungsabschnitt (41) beinhaltet, der thermisch mit der Rippe (43) an einer anderen Position als einem Scheitelpunkt (43A) der Rippe (43) verbunden ist und thermisch mit einer elektronischen Komponente (31) verbunden ist; und
Einfüllen des ersten Materials in die Form (51), um den Hauptkörper (12) zu bilden, und Integrieren des Hauptkörpers (12) und des den Hauptkörper (12) abdeckenden wärmeableitenden Blechs (40), wobei das erste Material in die Form (51) eingefüllt ist, und ein Schutzabschnitt (15), der mindestens einen Abschnitt eines Scheitelpunktes (43A) der Rippe (43) abdeckt, aus dem ersten Material gebildet ist.

10. Herstellungsverfahren für eine wärmeabgebende Komponente (50) nach Anspruch 9, wobei:
ein Soll-Zustand angenommen wird, in dem das wärmeableitende Blech (40), das so gebogen ist, dass es die Rippe (43) bildet, innerhalb der Form (51) untergebracht ist, ein Spalt (68) zwischen dem Scheitelpunkt (43A) der Rippe (43) und einer Bodenseite (63B) eines Hohlraums (63), der innerhalb der Form (51) ausgebildet ist, vorgesehen ist, und ein Verbindungsanschluss (45/46) an dem Scheitelpunkt (43A) der Rippe (43) gebildet ist; und,
im Soll-Zustand das erste Material in die Form (51) zur Innenseite der Rippe (43) gespritzt wird, das erste Material an der Innenseite der Rippe (43) durch den Verbindungsanschluss (45/46) hindurchgeht und in den Spalt (68) zwischen dem Scheitelpunkt (43A) der Rippe (43) und der Bodenseite (63B) des Hohlraums (63) füllt, um den Schutzabschnitt (15) aus dem ersten Material zu bilden.

11. Herstellungsverfahren für eine wärmeabgebende Komponente (50) nach Anspruch 9 oder Anspruch 10, wobei:
das erste Material in die Form (51) gefüllt ist, und ein aus dem ersten Material gebildeter Abdeckabschnitt (16) mindestens einen Abschnitt eines Bodenabschnitts (44A) einer Nut (44) abdeckt, die zwischen der Rippe (43) und einer anderen Rippe (43) gebildet ist, die thermisch mit der Rippe (43) an entsprechenden Positionen, außer an den Scheitelabschnitten (43A) der Rippen (43), verbunden ist.

## Revendications

1. Composant de dissipation de chaleur (50) comprenant :
un corps principal (12) formé à partir d'un premier matériau ; et
une feuille de dissipation de chaleur (40) qui est formée à partir d'un second matériau ayant une conductivité thermique supérieure au premier matériau, qui recouvre le corps principal (12) et qui comprend une ailette (43), et une partie de connexion (41) qui est reliée thermiquement à l'ailette (43) en une position autre qu'un sommet (43A) de l'ailette (43) et qui est également reliée thermiquement à un composant électronique (31) ;
le composant de dissipation la chaleur (50), comprenant en outre une partie de protection (15) qui est formée à partir du premier matériau et qui couvre au moins une partie du sommet (43A) de l'ailette (43) ;
dans lequel la feuille de dissipation de chaleur (40) comprend en outre une autre ailette (43) qui est reliée thermiquement à l'ailette (43) en des positions respectives autres que les sommets (43A) des ailettes (43).

2. Composant de dissipation de chaleur (50) selon la revendication 1, dans lequel :
la partie de protection (15) est prévue sur le côté du sommet (43A) de l'ailette (43) ; et
une partie plus éloignée d'un côté d'extrémité de base (43) de l'ailette (43) que la partie de protection (15) est exposée au niveau d'une partie de face latérale (43B) de l'ailette (43).

3. Composant de dissipation de chaleur (50) selon la revendication 1 ou la revendication 2, dans lequel :
l'ailette (43) et l'autre ailette (43) s'étendent avec une direction de longueur le long d'une direction recoupant une direction de disposition en réseau de l'ailette (43) et de l'autre ailette (43) ;
un orifice de communication (45/46) est formé dans le sommet (43A) de l'ailette (43) ; et
le corps principal (12) et la partie de protection (15) sont formés d'un seul tenant à travers une partie de couplage formée au niveau de la partie de communication (45/46).

4. Composant de dissipation de chaleur (50) selon l'une quelconque des revendications 1 à 3, comprenant en outre une partie de recouvrement (16) formée du premier matériau et qui recouvre au moins une partie d'une partie inférieure (44A) d'une gorge (44) formée entre l'ailette (43) et l'autre ailette (43).

5. Composant de dissipation de chaleur (50) selon la revendication 4, dans lequel :
la partie de recouvrement (16) est prévue du côté de la partie inférieure (44A) de la gorge (44) ; et
une partie située entre la partie de recouvrement (16) et la partie de protection (15) est exposée au niveau d'une partie de face latérale (43B) de l'ailette (43).

6. Composant de dissipation la chaleur (50) selon la revendication 4 ou la revendication 5, dans lequel :
l'ailette (43) s'étend avec une direction de longueur le long d'une direction recoupant une direction de disposition en réseau de l'ailette (43) et de l'autre ailette (43) ;
la gorge (44) entre l'ailette (43) et l'autre ailette (43) comprend une ouverture ; et
une longueur (L2) de la feuille de dissipation de chaleur (40) dans la direction de longueur est plus courte qu'une longueur (L1) du corps principal (12) dans la direction de longueur.

7. Composant de dissipation la chaleur (50) selon la revendication 6, dans lequel :
la partie inférieure (44A) est dans une position plus basse dans une direction de profondeur de la gorge (44) que la partie de connexion (41).

8. Composant de dissipation la chaleur (50) selon l'une quelconque des revendications 1 à 7, dans lequel au moins une partie d'une surface d'une partie en résine (12, 15, 16) comprenant le corps principal (12) et formée à partir du premier matériau est soumise à un traitement anti-salissure (22/23/24).

9. Procédé de fabrication d'un composant de dissipation de chaleur (50), le procédé de fabrication comprenant les étapes consistant à :
loger, dans un moule (51), une feuille de dissipation de chaleur (40) qui est formée d'un second matériau ayant une conductivité thermique supérieure à celle d'un premier matériau formant un corps principal (12) du composant de dissipation de chaleur (50), et qui comprend une ailette (43) et une partie de connexion (41) qui est reliée thermiquement à l'ailette (43) en une position autre qu'un sommet (43A) de l'ailette (43) et qui est reliée thermiquement à un composant électronique (31) ; et
introduire le premier matériau dans le moule (51) pour former le corps principal (12), et intégrer le corps principal (12) et la feuille de dissipation de chaleur (40) recouvrant le corps principal (12), dans lequel le premier matériau est introduit dans le moule (51), et une partie de protection (15) qui recouvre au moins une partie d'un sommet (43A) de l'ailette (43) est formée du premier matériau.

10. Procédé de fabrication d'un composant de dissipation de chaleur (50) selon la revendication 9, dans lequel :
un état établi est adopté, dans lequel la feuille de dissipation de chaleur (40) pliée de manière à former l'ailette (43) est reçue dans un côté intérieur du moule (51), un espace (68) est ménagé entre le sommet (43A) de l'ailette (43) et une face inférieure (63B) d'une cavité (63) formée dans le côté intérieur du moule (51), et un orifice de communication (45/46) est formé au niveau du sommet (43A) de l'ailette (43) ; et,
à l'état établi, le premier matériau est injecté dans le moule (51) en direction du côté intérieur de l'ailette (43), le premier matériau au niveau du côté intérieur de l'ailette (43) passe à travers l'orifice de communication (45/46) et remplit l'espace (68) situé entre le sommet (43A) de l'ailette (43) et la face inférieure (63B) de la cavité (63), de manière à former la partie de protection (15) à partir du premier matériau.

11. Procédé de fabrication d'un composant de dissipation de chaleur (50) selon la revendication 9 ou la revendication 10, dans lequel :
le premier matériau est introduit dans le moule (51) et une partie de recouvrement (16) formée du premier matériau recouvre au moins une partie d'une partie inférieure (44A) d'une gorge (44) formée entre l'ailette (43) et une autre ailette (43) qui est reliée thermiquement à l'ailette (43) en des positions respectives autres que les parties de sommet (43A) des ailettes (43).
